(19) Europäisches Patentamt / European Patent Office / Office européen des brevets

(11) **EP 3 938 794 B1**

(12) **EUROPÄISCHE PATENTSCHRIFT**

(45) Veröffentlichungstag und Bekanntmachung des Hinweises auf die Patenterteilung:
**14.12.2022 Patentblatt 2022/50**

(21) Anmeldenummer: **20712869.5**

(22) Anmeldetag: **11.03.2020**

(51) Internationale Patentklassifikation (IPC):
**G01R 31/28** (2006.01)   **G01R 31/42** (2006.01)
**G01R 31/26** (2020.01)   **G01K 3/10** (2006.01)

(52) Gemeinsame Patentklassifikation (CPC):
**G01R 31/2817; G01K 3/10; G01R 31/2642;
G01R 31/2849; G01R 31/2875; G01R 31/42;**
G01R 31/2619; G01R 31/2628

(86) Internationale Anmeldenummer:
**PCT/EP2020/056506**

(87) Internationale Veröffentlichungsnummer:
**WO 2020/182885 (17.09.2020 Gazette 2020/38)**

(54) **UMRICHTER UND VERFAHREN ZUR BEWERTUNG DER THERMISCHEN BELASTUNG EINES UMRICHTERS**

CONVERTER AND METHOD FOR ASSESSING THE THERMAL LOADING OF A CONVERTER

CONVERTISSEUR ET PROCÉDÉ D'ÉVALUATION DE LA CHARGE THERMIQUE D'UN CONVERTISSEUR

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorität: **12.03.2019 AT 502082019**

(43) Veröffentlichungstag der Anmeldung:
**19.01.2022 Patentblatt 2022/03**

(73) Patentinhaber: **Schneider Electric Power Drives
GmbH
1210 Wien (AT)**

(72) Erfinder: **HARTMANN, Michael
1040 Wien (AT)**

(74) Vertreter: **KLIMENT & HENHAPEL
Patentanwälte OG
Gonzagagasse 15/2
1010 Wien (AT)**

(56) Entgegenhaltungen:
DE-A1- 10 203 577    DE-A1-102009 032 063
DE-A1-102011 087 764    DE-A1-102013 221 587
DE-A1-102014 206 621    US-B1- 9 869 722

**Beschreibung**

Die Erfindung betrifft ein Verfahren zur Bewertung des Schädigungszustandes einer betrieblich belasteten Halbleiterbaugruppe, insbesondere eines Antriebsumrichters, mit zumindest einem auf oder in einem Trägeraufbau angeordneten Halbleiterbauelement, wobei eine innerhalb des Halbleiterbauelements auftretende Temperatur in Form einer Zeitreihe als hochzyklischer Last-Zeit-Verlauf ermittelt wird, dem mithilfe an sich bekannter Auswertealgorithmen ein erster Schädigungskennwert $LC_{PC}$ zugeordnet wird, und eine im Trägeraufbau auftretende Temperatur in Form einer Zeitreihe als niederzyklischer Last-Zeit-Verlauf ermittelt wird, dem mithilfe der an sich bekannten Auswertealgorithmen ein zweiter Schädigungskennwert $LC_{TC}$ zugeordnet wird, wobei es sich bei dem hochzyklischen Last-Zeit-Verlauf und dem niederzyklischen Last-Zeit-Verlauf jeweils um zeitveränderliche thermische Belastungen handelt, deren Schwingzyklen unterschiedlich rasch verlaufen, wobei die Schwingzyklen der hochzyklischen Belastungen rascher verlaufen als jene der niederzyklischen Belastungen, gemäß dem Oberbegriff von Anspruch 1.

Ein gattungsgemäßes Verfahren wurde in der DE 10 2013 221587 A1 beschrieben. Weitere Verfahren zur Bewertung eines Schädigungszustandes wurden in der DE 10 2011 087764 A1, DE 10 2014 206621 A1, DE 102 03 577 A1, DE 10 2009 032063 A1 und US 9 869 722 B1 beschrieben.

Halbleiterbauelemente beinhalten in klassischer Bauweise einen oder mehrere unterschiedlich dotierte Bereiche zur Erzielung ihrer Funktion, etwa als Dioden oder Transistoren. Während ihres Betriebes entsteht Verlustleistung, die zu einer Erwärmung des Halbleiterbauelements führt, die in der Regel mithilfe der Sperrschichttemperatur des betreffenden Halbleiterbauelements quantifiziert wird. Im Folgenden werden unter Halbleiterbauelemente aber nicht nur einzelne Bauteile wie Dioden oder Transistoren verstanden, sondern auch Kombinationen einer Mehrzahl elektrisch verbundener Halbleiterbauelemente in Form integrierter Schaltungen. Solche Halbleiterbauelemente werden auch als "Chips" (engl. "die") bezeichnet. Diese Chips sind auf oder in einem Trägeraufbau gehalten, der die Stromführung zum Halbleiterbauelement bewerkstelligt und vom Halbleiterbauelement abgegebene Wärme aufnimmt und abführt. Die Anordnung aus Halbleiterbauelement und Trägeraufbau wird im Folgenden als Halbleiterbaugruppe bezeichnet. Ein Beispiel für einen solchen Trägeraufbau sind Leiterplatten, auf denen die Halbleiterbauelemente zumeist in Form gehäuster Chips befestigt und elektrisch kontaktiert sind. Ein weiteres Beispiel für einen möglichen Trägeraufbau sind DCB (direct copper bonded)-Substrate, auf denen die Halbleiterbauelemente zumeist in Form ungehäuster Chips ("bare dies") befestigt und mit Bond-Drähten verbunden sind. Des Weiteren sind insbesondere zur Herstellung von Leistungsmodulen Einbetttechnologien bekannt, bei denen Halbleiterbauelemente wie beispielsweise MOSFETs oder IGBTs in den Trägeraufbau eingebettet werden (z.B. "$p^2$-Packs"). Der Trägeraufbau weist in der Regel eine Bodenplatte auf, die mit einem Kühlkörper versehen ist, um die im Trägeraufbau vorliegende Wärme abzuführen.

Während des Betriebes von Halbleiterbauelementen ergeben sich in vielen Anwendungen Probleme aufgrund der Wärmeentwicklung durch Leit- und Schaltverluste, die das Halbleiterbauelement und den Trägeraufbau thermisch belasten. Diese thermische Belastung kann die Lebensdauer der Halbleiterbaugruppe reduzieren und bis zum Ausfall der betreffenden Halbleiterbaugruppe führen. Ein Beispiel sind etwa Antriebsumrichter für Motoren oder Generatoren. Die thermischen Belastungen eines Halbleiterbauelements sind dabei einerseits von den Betriebsbedingungen abhängig, unter denen das betreffende Halbleiterbauelement betrieben wird, und andererseits von der Auslegung des Halbleiterbauelements selbst.

Da diese thermischen Belastungen die Lebensdauer der Halbleiterbaugruppe reduzieren können, stellt sich daher die Frage der Ausfallswahrscheinlichkeit und somit der Betriebssicherheit der Halbleiterbaugruppe. Dabei wäre es wünschenswert über Methoden zur Bewertung des thermischen Schädigungszustandes einer betrieblich belasteten Halbleiterbaugruppe zu verfügen, die einen Rückschluss auf die verbrauchte Lebensdauer der Halbleiterbaugruppe erlauben. Mithilfe solcher Methoden könnten etwa Wartungsintervalle optimiert werden. Eine andere Nutzungsmöglichkeit solcher Methoden wäre aber auch die Detektion unerwünschter oder seitens des Herstellers unerwarteter Belastungszustände, etwa infolge einer ungeeigneten Belastung seitens des Anwenders, oder auch infolge einer falschen Auslegung der Halbleiterbauelemente. Idealerweise erhält der Anwender bereits während des Betriebes Rückmeldung über den thermischen Schädigungszustand, um bereits frühzeitig Vorkehrungen für einen längeren, ausfallsicheren Betrieb der Halbleiterbaugruppe treffen zu können, etwa mithilfe einer Änderung der Betriebsparameter oder eines Austausches der betreffenden Halbleiterbaugruppe. Der Schädigungszustand stellt dabei gewissermaßen das Integral über vergangene und aktuelle thermische Belastungen der Halbleiterbaugruppe dar.

Die Anforderungen an die Betriebssicherheit von Halbleiterbaugruppen sind dabei mitunter sehr hoch. In der Luftfahrt beispielsweise wird in der Regel eine Ausfallsicherheit über 24 Jahre bei 100.000 Flugstunden vorgegeben. In der Automobilindustrie werden in der Regel 15 Jahre bei 10.000 Betriebsstunden, was einer Fahrleistung von etwa 300.000 km entspricht, vorgegeben. Bei industriellen Antrieben liegen die Vorgaben an die ausfallssichere Betriebszeit in der Regel bei 5-20 Jahren oder 60.000 Betriebsstunden unter Volllast. Bekannte Methoden zur Bewertung der verbleibenden Lebensdauer einer Halbleiterbaugruppe beruhen zumeist auf Zähler, die etwa die Anzahl der Ein- und Ausschaltvorgänge oder die Betriebszeit detektieren und mit vorgegebenen Werten vergleichen, um eine restliche Lebensdauer abzuschätzen. Die Anzahl der Ein- und Ausschaltvorgänge oder die Betriebszeit lassen allerdings nur begrenzten Rückschluss auf die tatsächliche thermische Belastung einer Halbleiterbaugruppe zu und liefern daher nur unzuverlässige Resultate.

Daher wurde seitens der Hersteller von Halbleiterbauelementen versucht, die Lebensdauer von Halbleiterbauelementen anhand von Belastungstests zu ermitteln, und dem Anwender die aus den Belastungstests gewonnenen Informationen bezüglich der zu erwartenden Lebensdauer eines Halbleiterbauelements bereit zu stellen. Beispielsweise können die in solchen Tests erreichten Sperrschichttemperaturen mit der zu erwartenden Lebensdauer des betreffenden Halbleiterbauelements in Zusammenhang gebracht werden. Je höher die Sperrschichttemperatur im Zuge des Betriebes ist, desto kürzer wird auch die Lebensdauer sein. Diese Vorgangsweise setzt aber voraus, dass die Belastungen im Zuge der Belastungstests seitens des Herstellers mit den tatsächlichen betrieblichen Belastungen durch den Anwender vergleichbar sind, was aber zumeist nicht der Fall ist. Tatsächlich erfolgt der Betrieb von Halbleiterbaugruppen mitunter unter gänzlich anderen Betriebsbedingungen als vom Hersteller erwartet.

Zudem stellt sich das Problem, dass nicht nur das Halbleiterbauelement ausfallsgefährdet ist, sondern auch der Trägeraufbau der Halbleiterbaugruppe. Da Halbleiterbaugruppen aus Materialien mit verschiedenen thermischen Eigenschaften, insbesondere verschiedenen thermischen Ausdehnungskoeffizienten, hergestellt werden, kann es aufgrund der zeitlich veränderlichen Belastung zu mechanischen Spannungszuständen kommen. Eine zyklische thermische Belastung kann folglich mechanische Beschädigungen, wie etwa Schichtablösung, Ablösung von Anschlüssen oder Ermüdungsbrüche bewirken. Auch diese Belastungen müssen daher in einer Bewertung des thermischen Belastungszustandes einer betrieblich belasteten Halbleiterbaugruppe berücksichtigt werden, um eine zuverlässige Abschätzung der verbleibenden Lebensdauer zu erhalten.

Es ist daher das Ziel der Erfindung Verfahren zur Bewertung des Schädigungszustandes einer betrieblich belasteten Halbleiterbaugruppe bereitzustellen, die es nicht nur ermöglichen den Schädigungszustand für die gesamte Halbleiterbaugruppe abzuschätzen, sondern auch hinreichend genau sind, um auch unerwartete oder unerwünschte Belastungszustände und somit eine vorschnelle Minderung der verbleibenden Lebensdauer der Halbleiterbaugruppe zu detektieren. Diese Verfahren sollen dabei bereits während des Betriebes der Halbleiterbaugruppe laufende Belastungsevaluierungen ermöglichen. Diese Ziele werden durch die Merkmale von Anspruch 1 erreicht.

Anspruch 1 betrifft ein Verfahren zur Bewertung des Schädigungszustandes einer betrieblich belasteten Halbleiterbaugruppe, insbesondere eines Antriebsumrichters, mit zumindest einem auf oder in einem Trägeraufbau angeordneten Halbleiterbauelement, wobei eine innerhalb des Halbleiterbauelements auftretende Temperatur $T_j$ in Form einer Zeitreihe als hochzyklischer Last-Zeit-Verlauf ermittelt wird, dem mithilfe an sich bekannter Auswertealgorithmen ein erster Schädigungskennwert $LC_{PC}$ zugeordnet wird, und eine im Trägeraufbau auftretende Temperatur $T_C$ in Form einer Zeitreihe als niederzyklischer Last-Zeit-Verlauf ermittelt wird, dem mithilfe der an sich bekannten Auswertealgorithmen ein zweiter Schädigungskennwert $LC_{TC}$ zugeordnet wird, wobei es sich bei dem hochzyklischen Last-Zeit-Verlauf und dem niederzyklischen Last-Zeit-Verlauf jeweils um zeitveränderliche thermische Belastungen handelt, deren Schwingzyklen unterschiedlich rasch verlaufen, wobei die Schwingzyklen der hochzyklischen Belastungen rascher verlaufen als jene der niederzyklischen Belastungen. Erfindungsgemäß wird hierbei vorgeschlagen, dass der erste Schädigungskennwert $LC_{PC}$ zur Identifizierung eines hochzyklischen Ist-Betriebszustandsbereiches der Halbleiterbaugruppe durch Vergleich des ersten Schädigungskennwertes $LC_{PC}$ mit einem vorgegebenen ersten Referenzwert $LC_{PC,ref}$ einem unkritischen, einem kritischen und einem überkritischen Betriebszustandsbereich für hochzyklische Belastungen der Halbleiterbaugruppe zugeordnet wird, und der zweite Schädigungskennwert $LC_{TC}$ zur Identifizierung eines niederzyklischen Ist-Betriebszustandsbereiches der Halbleiterbaugruppe durch Vergleich des zweiten Schädigungskennwertes $LC_{TC}$ mit einem vorgegebenen zweiten Referenzwert $LC_{TC,ref}$ einem unkritischen, einem kritischen und einem überkritischen Betriebszustandsbereich für niederzyklische Belastungen der Halbleiterbaugruppe zugeordnet wird, und in weiterer Folge ein erstes Anzeigesignal generiert wird, falls sowohl der hochzyklische als auch der niederzyklische IST-Betriebszustandsbereich einem unkritischen Betriebszustandsbereich entsprechen, ein zweites Anzeigesignal generiert wird, falls der hochzyklische oder der niederzyklische IST-Betriebszustandsbereich einem kritischen Betriebszustandsbereich und beide keinem überkritischen Betriebszustandsbereich entsprechen, und ein drittes Anzeigesignal generiert wird, falls der hochzyklische oder der niederzyklische IST-Betriebszustandsbereich einem überkritischen Betriebszustandsbereich entspricht, wobei

- ) es sich beim zeitlichen Verlauf des ersten Referenzwertes ($LC_{PC,ref}$) sowie des zweiten Referenzwertes ($LC_{TC,ref}$) während des Betriebes der Halbleiterbaugruppe jeweils um eine vorgegebene, monoton ansteigende Funktion handelt, die bei Erreichen der maximalen Lebensdauer den Wert 1 annimmt, und
- ) die Ermittlung des ersten Schädigungskennwertes ($LC_{PC}$) während des Betriebes des Umrichters oftmals in vorgegebenen Zeitabständen anhand von aktuell ermittelten hochzyklischen Last-Zeitverläufen wiederholt und mit dem ersten Referenzwert ($LC_{PC,ref}$) verglichen wird, und
- ) die Ermittlung des zweiten Schädigungskennwertes ($LC_{TC}$) während des Betriebes des Umrichters oftmals in vorgegebenen Zeitabständen anhand von aktuell ermittelten niederzyklischen Last-Zeitverläufen wiederholt und mit dem zweiten Referenzwert ($LC_{TC,ref}$) verglichen wird, um jeweils ein Anzeigesignal zum aktuellen Belastungszustand zu generieren.

Erfindungsgemäß wird somit zur Bewertung des Schädigungszustandes der Halbleiterbaugruppe aufgrund thermischer Belastungen, der im Folgenden auch als thermischer Schädigungszustand bezeichnet wird, zwischen akkumulierten Schäden aufgrund hochzyklischer und niederzyklischer Belastungen unterschieden. Dabei handelt es sich jeweils um zeitveränderliche thermische Belastungen, deren Schwingzyklen - im Folgenden auch als Belastungszyklen bezeichnet - unterschiedlich rasch verlaufen, wobei die Schwingzyklen der hochzyklischen Belastungen rascher verlaufen als jene der niederzyklischen Belastungen. Das Konzept der Charakterisierung von Schwingzyklen und der Ableitung von Schädigungskennwerten wurde an sich in der Werkstoffkunde entwickelt, wo Materialien einer schwingenden Belastung ausgesetzt werden und deren Ermüdung bewertet wird. Dabei werden Materialien beispielsweise in Dauerschwingversuchen auf Zug und/oder Druck zyklisch belastet, wobei auch von

Schwingspielen gesprochen wird. Zyklische Belastungen mit hohen Lastwechseln werden dabei als hochzyklische Ermüdung bezeichnet, und zyklische Belastungen mit niedrigen Lastwechseln als niederzyklische Ermüdung. Dabei wurde beobachtet, dass statisch-mechanische Kennwerte eines Materials wie Streckgrenze oder Zugfestigkeit für die Festigkeitsberechnung kaum oder nur bedingt tauglich sind. Stattdessen müssen zyklische Festigkeitsdaten berücksichtigt werden, die in so genannten Wöhler-Versuchen ermittelt werden und in Wöhlerdiagrammen als Wöhlerkurven graphisch dargestellt werden. Des Weiteren wurden in der Werkstoffkunde Modelle entwickelt, aus denen Lebensdauergleichungen abgeleitet werden, die anhand zyklischer Festigkeitsdaten eine Berechnung der Lebensdauer des Bauteiles zumeist in Form der Anzahl der Schwingzyklen erlauben. Diese Modelle orientieren sich zumeist an Wöhlerkurven und beschreiben sie mithilfe eines Potenzansatzes. Das in der Werkstoffkunde bekannte Coffin-Manson-Modell beispielsweise stellt einen Zusammenhang zwischen der plastischen Dehnung sowie der Lebensdauer her, wobei die plastische Dehnung mit einem Exponenten und einem Koeffizienten versehen wird, die beide experimentell oder durch Simulation zu bestimmen sind.

Erfindungsgemäß werden diese Konzepte der Werkstoffkunde auf die Bewertung der thermischen Schäden von Halbleiterbaugruppen übertragen, wobei freilich keine Schwingspiele mechanischer Schwingungen der Halbleiterbaugruppe betrachtet werden, sondern Schwingspiele der Temperatur. Erfindungsgemäß werden des Weiteren die Schwingspiele einer innerhalb des Halbleiterbauelements auftretenden Temperatur und einer im Trägeraufbau auftretenden Temperatur herangezogen. Bei der innerhalb des Halbleiterbauelements auftretenden Temperatur handelt es sich in der Regel um eine Sperrschichttemperatur, und bei der im Trägeraufbau auftretenden Temperatur beispielsweise um eine an der Bodenplatte des Trägeraufbaus gemessene Temperatur.

Zunächst wird auf die innerhalb des Halbleiterbauelements auftretende Temperatur $T_j$ eingegangen, bei der es sich in der Regel um eine Sperrschichttemperatur handeln wird und die im Folgenden auch als "innere" Temperatur $T_j$ bezeichnet wird. Diese innere Temperatur $T_j$ beruht in erster Linie auf der Verlustleistung infolge eines elektrischen Stromdurchflusses durch das Halbleiterelement. Da die Belastungen des Halbleiterbauelements in der Regel zeitlich mit der Stromperiode und bei Antriebsumrichter auch mit der Motordrehzahl variieren, zeigt beispielsweise auch die Sperrschichttemperatur und somit die Temperaturbelastung des gesamten Halbleiterbauelements eine Zeitabhängigkeit. Während der elektrischen Belastung steigt die innere Temperatur $T_j$ an und erreicht bei Beendigung der elektrischen Belastung eine Maximaltemperatur $T_{j,max}$. Die innere Temperatur $T_j$ wird in weiterer Folge wieder abnehmen und erreicht vor Beginn der neuerlichen Belastung einen Minimalwert $T_{j,min}$. Die Differenz ist der Temperaturhub $\Delta T_j$. Des Weiteren kann auch ein Mittelwert $T_{j,m}$ gebildet werden. Die Anzahl der Belastungszyklen wird im Folgenden mit $N_j$ bezeichnet, wobei die maximale Anzahl der Belastungszyklen bis zum Ausfall des Halbleiterbauelements als $N_{j,f}$ bezeichnet wird. Der Temperaturhub $\Delta T_j$ und der Mittelwert $T_{j,m}$ können während des Betriebes des Halbleiterbauelements ermittelt werden. Aus diesen Werten kann die maximale Anzahl $N_{j,f}$ abgeleitet werden, wofür unterschiedliche und an sich bekannte mathematische Modelle zur Verfügung stehen, wie noch näher ausgeführt werden wird. Aus dieser maximalen Anzahl $N_{j,f}$ kann ein erster Schädigungskennwert $LC_{PC}$ abgeleitet werden, der die verbrauchte Lebensdauer des Halbleiterbauelements kennzeichnet, wie ebenfalls noch näher erläutert werden wird. Ein Ausfall des Halbleiterbauelements kann beispielsweise durch Beschädigung des Halbleiters selbst, aber auch durch das Ablösen der Bond-Drähte verursacht werden, oder durch Beschädigung der Lötstellen des Chips am Trägeraufbau.

In weiterer Folge wird auf die außerhalb des Halbleiterbauelements im Trägeraufbau auftretende Temperatur $T_C$ eingegangen, die im Folgenden als "äußere" Temperatur $T_C$ bezeichnet wird. Halbleiterbauelemente werden in der Regel so am oder im Trägeraufbau befestigt, dass die Wärmeübertragung vom Halbleiterbauelement auf den Trägeraufbau optimiert wird, um Wärme effizient abzuführen und beispielsweise einem Kühlkörper zuzuführen. Dadurch kommt es auch zu einer Erwärmung des Trägeraufbaus, die erfindungsgemäß anhand einer im Trägeraufbau auftretenden, äußeren Temperatur $T_C$ charakterisiert wird, beispielsweise anhand einer an der Bodenplatte des Trägeraufbaus gemessenen Temperatur $T_C$. Auch diese äußere Temperatur $T_C$ des Trägeraufbaus weist einen zyklischen Verlauf auf, der jedoch aufgrund höherer thermischer Kapazitäten des Aufbaus durch langsamere Veränderungen im Vergleich zur inneren Temperatur $T_j$ des Halbleiterbauelements gekennzeichnet ist. Dennoch können auch für die äußere Temperatur $T_C$ ein Maximalwert $T_{C,max}$, ein Minimalwert $T_{C,min}$, ein Temperaturhub $\Delta T_C$ und eine mittlere Temperatur $T_{C,m}$ ermittelt werden. Die Anzahl der Belastungszyklen für den Trägeraufbau wird im Folgenden mit $N_C$ bezeichnet, wobei die maximale Anzahl der Belastungszyklen bis zum Ausfall des Trägeraufbaus als $N_{C,f}$ bezeichnet wird. Der Temperaturhub $\Delta T_C$ und der Mittelwert $T_{C,m}$ können während des Betriebes des Halbleiterbauelements ermittelt werden. Aus diesen Werten kann die maximale Anzahl der Belastungszyklen $N_{C,f}$ abgeleitet werden, wofür wie bereits erwähnt unterschiedliche und an sich bekannte mathematische Modelle zur Verfügung stehen, wie noch näher ausgeführt werden wird. Aus dieser maximalen Anzahl $N_{C,f}$ kann ein zweiter Schädigungskennwert $LC_{TC}$ abgeleitet werden, der die verbrauchte Lebensdauer des Trägeraufbaus kennzeichnet, wie ebenfalls noch näher erläutert werden wird. Ein Ausfall des Trägeraufbaus kann beispielsweise durch Beschädigung der Lötstellen innerhalb des Trägeraufbaus oder durch Beschädigung der thermischen Schnittstelle zwischen dem Trägeraufbau und dem Kühlkörper verursacht werden.

Erfindungsgemäß wird in weiterer Folge der erste Schädigungskennwert $LC_{PC}$ zur Identifizierung eines hochzyklischen Ist-Betriebszustandsbereiches der Halbleiterbaugruppe einem unkritischen, einem kritischen und einem überkritischen Betriebszustandsbereich für hochzyklische Belastungen der Halbleiterbaugruppe zugeordnet, und der zweite Schädigungskennwert $LC_{TC}$ zur Identifizierung eines niederzyklischen Ist-Betriebszustandsbereiches der Halbleiterbaugruppe einem unkritischen, einem kritischen und einem überkritischen Betriebszustandsbereich für niederzyklische Belastungen der Halbleiterbaugruppe.

In weiterer Folge bedarf es eines Kriteriums, anhand dessen die Bewertung und Anzeige eines Schädigungszustandes der Halbleiterbaugruppe vorgenommen wird. Erfindungsgemäß wird hierfür vorgeschlagen, dass ein erstes Anzeigesignal generiert wird, falls sowohl der hochzyklische als auch der niederzyklische IST-Betriebszustandsbereich einem unkritischen Betriebszustandsbereich entsprechen, ein zweites Anzeigesignal generiert wird, falls der hochzyklische oder der niederzyklische IST-Betriebszustandsbereich einem kritischen Betriebszustandsbereich und beide keinem überkritischen Betriebszustandsbereich entsprechen, und ein drittes Anzeigesignal generiert wird, falls der hochzyklische oder der niederzyklische IST-Betriebszustandsbereich einem überkritischen Betriebszustandsbereich entspricht. Dieses Kriterium sieht somit vor, dass immer der höhere des hochzyklischen und des niederzyklischen Ist-Betriebszustandsbereiches die Bewertung des Belastungszustandes sowie das Anzeigesignal bestimmt. Bei dem ersten Anzeigesignal kann es sich etwa um ein grünes Leuchtsignal handeln, bei dem zweiten Anzeigesignal um ein gelbes Leuchtsignal und bei dem dritten Anzeigesignal um ein rotes Leuchtsignal.

Vorzugsweise erfolgt die Zuordnung zu einem unkritischen, einem kritischen und einem überkritischen Betriebszustandsbereich durch Vergleich des ersten Schädigungskennwertes $LC_{PC}$ mit einem vorgegebenen ersten Referenzwert $LC_{PC,ref}$ und des zweiten Schädigungskennwertes $LC_{TC}$ mit einem vorgegebenen zweiten Referenzwert $LC_{TC,ref}$, wobei ein unkritischer Betriebszustandsbereich jeweils dann vorliegt, falls der jeweilige Schädigungskennwert $LC_{PC}$, $LC_{TC}$ unterhalb eines Abweichungsbereiches des ihm jeweils zugeordneten Referenzwertes $LC_{PC,ref}$, $LC_{TC,ref}$ liegt, ein kritischer Betriebszustandsbereich jeweils dann vorliegt, falls der Schädigungskennwert $LC_{PC}$, $LC_{TC}$ innerhalb des Abweichungsbereiches des ihm jeweils zugeordneten Referenzwertes $LC_{PC,ref}$, $LC_{TC,ref}$ liegt, und ein überkritischer Betriebszustandsbereich jeweils dann vorliegt, falls der Schädigungskennwert $LC_{PC}$, $LC_{TC}$ oberhalb des Abweichungsbereiches des ihm jeweils zugeordneten Referenzwertes $LC_{PC,ref}$, $LC_{TC,ref}$ liegt. Der Abweichungsbereich der Referenzwerte $LC_{PC,ref}$, $LC_{TC,ref}$ kann beispielsweise im Wertebereich von 80-100% der Referenzwerte $LC_{PC,ref}$, $LC_{TC,ref}$ liegen. Ein unkritischer Betriebszustandsbereich würde in diesem Fall dann vorliegen, falls beispielsweise der erste Schädigungskennwert $LC_{PC}$ weniger als 80% des ersten Referenzwertes $LC_{PC,ref}$ beträgt. Ein kritischer Betriebszustandsbereich würde dann vorliegen, falls der erste Schädigungskennwert $LC_{PC}$ innerhalb des Abweichungsbereiches von 80-100% des ersten Referenzwertes $LC_{PC,ref}$ liegt. Ein überkritischer Betriebszustandsbereich würde dann vorliegen, falls der erste Schädigungskennwert $LC_{PC}$ oberhalb des ersten Referenzwertes $LC_{PC,ref}$ liegt. Letzteres stellt eine unerwartet starke Belastung der Halbleiterbaugruppe dar, über die der Anwender Bescheid wissen sollte, um in geeigneter Weise intervenieren zu können. Freilich können die unkritischen, kritischen und überkritischen Betriebszustandsbereiche auch in Form anderer Prozentabweichungen für den Abweichungsbereich gewählt werden, zudem könnten für hochzyklische und niederzyklische Belastungen jeweils unterschiedliche Prozentabweichungen zur Festlegung der unkritischen, kritischen und überkritischen Betriebszustandsbereiche gewählt werden.

In weiterer Folge werden bevorzugte Methoden zur Ermittlung der Schädigungskennwerte $LC_{PC}$, $LC_{TC}$ und der Referenzwerte $LC_{PC,ref}$, $LC_{TC,ref}$ vorgeschlagen.

Zur Ermittlung des ersten Schädigungskennwertes $LC_{PC}$ wird vorzugsweise vorgeschlagen, dass die Auswertealgorithmen eine anhand des hochzyklischen Last-Zeitverlaufes durchgeführte Rainflow-Zählung umfassen, mittels der für die innerhalb des Halbleiterbauelements auftretende Temperatur $T_j$ die Häufigkeit eines Temperaturhubes $\Delta T_j$ einer bestimmten Größenordnung für unterschiedliche Größenordnungen gezählt wird, sowie eine rechnerische Ermittlung der maximalen Anzahl an Belastungszyklen $N_{j,f}$ für einen Temperaturhub $\Delta T_j$ einer jeden Größenordnung, wobei es sich beim ersten Schädigungskennwert $LC_{PC}$ um die Summe der Quotienten aus der Häufigkeit eines Temperaturhubes $\Delta T_j$ einer bestimmten Größenordnung für die innerhalb des Halbleiterbauelements auftretende Temperatur $T_j$ zur maximalen Anzahl an Belastungszyklen $N_{j,f}$ für einen Temperaturhub $\Delta T_j$ derselben Größenordnung handelt. Mittels Rainflow-Zählung werden einzelne Schwingspiele (geschlossene Hystereseschleifen) eines Last-Zeitverlaufes separiert und deren Häufigkeit gezählt, wofür geeignete Software zur Verfügung steht. Die vorgeschlagene Methode der Rainflow-Zählung hat sich als sehr robust gegenüber der Abtastrate des zu analysierenden Last-Zeitverlaufes erwiesen und liefert im Rahmen der vorliegenden Erfindung eine Matrix, bei der für unterschiedliche Größenordnungen des Temperaturhubs $\Delta T_j$ die entsprechende Häufigkeit ihres Auftretens angegeben wird. Die Größenordnungen können auch als Klassen bezeichnet werden, denen ein ermittelter Temperaturhub $\Delta T_j$ zugeordnet wird. Bei der Summenbildung der erwähnten Quotienten handelt es sich um eine Abwandlung der als "Miner's Rule" bekannten Vorgangsweise. Dabei wird davon ausgegangen, dass jeder Belastungszyklus einen kumulativen Schaden verursacht, wobei ein kleinerer Temperaturhub $\Delta T_j$ einen vergleichsweise kleineren Schaden verursacht als ein größerer Temperaturhub $\Delta T_j$. Wird die Häufigkeit eines bestimmten Temperaturhubes $\Delta T_j$ in Relation zur errechneten maximalen Anzahl an Belastungszyklen $N_{j,f}$ für den betreffenden Temperaturhub $\Delta T_j$ gesetzt, so ergibt sich ein Kennwert für den Verbrauch an Lebenszeit. Die Summe dieses Verbrauches für jede Größenordnung des Temperaturhubes $\Delta T_j$ ergibt den ersten Schädigungskennwert $LC_{PC}$, der während des Betriebes der Halbleiterbaugruppe stetig zunimmt und bei Erreichen der maximalen Lebensdauer den Wert 1 annimmt.

Für die rechnerische Ermittlung der maximalen Anzahl an Belastungszyklen $N_{j,f}$ für den Temperaturhub $\Delta T_j$ einer bestimmten Größenordnung wird vorgeschlagen, dass aus dem Temperaturhub $\Delta T_j$ einer bestimmten Größenordnung für die innerhalb des Halbleiterbauelements auftretende Temperatur $T_j$ zunächst ein Mittelwert $T_{j,m}$ für die innerhalb des Halbleiterbauelements auftretende Temperatur $T_j$ für die betreffende Größenordnung ermittelt wird, und die rechnerische Ermittlung der maximalen Anzahl an Belastungszyklen $N_{j,f}$ für den Temperaturhub $\Delta T_j$ einer jeden Größenordnung gemäß der folgenden Formel errechnet wird:

$$N_{j,f} = A \cdot \Delta T_j^{\alpha} \cdot \exp(c/(k_B \cdot T_{j,m}))$$

wobei es sich bei A, c und $\alpha$ um empirisch oder mittels Simulation für die betreffende Halbleiterbaugruppe bestimmte Parameter handelt und $k_B = 1.38 \cdot 10^{-23}$ J/K ist.

Bei der vorgeschlagenen Formel handelt es sich um das bereits erwähnte Coffin-Manson-Modell hinsichtlich des Terms $A \cdot \Delta T_j^{\alpha}$, der aber gemäß des vorgeschlagenen Modells um eine Exponentialfunktion, die eine Aktivierungsenergie c und die Boltzmann-Konstante $k_B$ enthält, erweitert wurde. Anhand der angegebenen Formel lässt sich für gegebene Werte für den Temperaturhub $\Delta T$ und den Mittelwert $T_m$ für jede Größenordnung des Temperaturhubes $\Delta T$ eine maximale Anzahl an Belastungszyklen $N_{j,f}$ für hochzyklische Belastungen errechnen, bis es zum Versagen der Halbleiterbaugruppe kommt. Die Ermittlung des Mittelwertes $T_m$ erfolgt bei bekanntem Temperaturhub $\Delta T$ anhand der Formel

$$T_m = T_{min} + (T_{max} - T_{min})/2$$

Zur Ermittlung des ersten Referenzwertes $LC_{PC,ref}$ für den ersten Schädigungskennwert $LC_{PC}$ kann in analoger Weise vorgegangen werden, wobei jedoch ein erwarteter hochzyklischer Referenz-Last-Zeitverlauf herangezogen wird, und anhand des erwarteten hochzyklischen Referenz-Last-Zeitverlaufes eine Rainflow-Zählung durchgeführt wird, mittels der für die innerhalb des Halbleiterbauelements auftretende Temperatur $T_{j,ref}$ die Häufigkeit eines Temperaturhubes $\Delta T_{j,ref}$ einer bestimmten Größenordnung für unterschiedliche Größenordnungen gezählt wird, sowie eine rechnerische Ermittlung der maximalen Anzahl an Belastungszyklen $N_{j,f,ref}$ für einen Temperaturhub $\Delta T_{j,ref}$ einer jeden Größenordnung, wobei es sich beim ersten Referenzwert $LC_{PC,ref}$ um die Summe der Quotienten aus der Häufigkeit eines Temperaturhubes $\Delta T_{j,ref}$ einer bestimmten Größenordnung für die innerhalb des Halbleiterbauelements auftretende Temperatur $T_{j,ref}$ zur maximalen Anzahl an Belastungszyklen $N_{j,f,ref}$ für einen Temperaturhub $\Delta T_{j,ref}$ derselben Größenordnung handelt. Zur Ermittlung der maximalen Anzahl an Belastungszyklen $N_{j,f,ref}$ für den Temperaturhub einer jeden Größenordnung kann wiederum zunächst aus dem Temperaturhub $\Delta T_{j,ref}$ einer bestimmten Größenordnung für die innerhalb des Halbleiterbauelements auftretende Temperatur $T_{j,ref}$ ein Mittelwert $T_{j,m,ref}$ für die innerhalb des Halbleiterbauelements auftretende Temperatur $T_{j,ref}$ für die betreffende Größenordnung ermittelt werden, und die rechnerische Ermittlung der maximalen Anzahl an Belastungszyklen $N_{j,f,ref}$ für den Temperaturhub $\Delta T_{j,ref}$ einer jeden Größenordnung gemäß der folgenden Formel errechnet werden:

$$N_{j,f,ref} = A \cdot \Delta T_{j,ref}^{\alpha} \cdot \exp(c/(k_B \cdot T_{j,m,ref}))$$

wobei es sich bei A, c und $\alpha$ um empirisch oder mittels Simulation für die betreffende Halbleiterbaugruppe bestimmte Parameter handelt und $k_B = 1.38 \cdot 10^{-23}$ J/K ist.

Diese Ermittlung des ersten Referenzwertes $LC_{PC,ref}$ wird für einen bestimmten Anwendungsfall nur einmal vorgenommen werden, und zwar in der Regel seitens des Herstellers des Antriebsumrichters. Bei Berücksichtigung des zeitlichen Verlaufes des Referenzwertes $LC_{PC,ref}$ während des Betriebes der Halbleiterbaugruppe ergibt sich eine monoton ansteigende Funktion, die bei Erreichen der maximalen Lebensdauer den Wert 1 annimmt, und die im Speicher eines Mikroprozessors des Umrichters gespeichert ist. Die Ermittlung des ersten Schädigungskennwertes $LC_{PC}$ wird hingegen während des Betriebes des Umrichters oftmals in vorgegebenen Zeitabständen anhand von aktuell ermittelten hochzyklischen Last-Zeitverläufen wiederholt und mit dem ersten Referenzwert $LC_{PC,ref}$ verglichen, um ein Anzeigesignal zum aktuellen Belastungszustand zu generieren. Bei Berücksichtigung des zeitlichen Verlaufes des ersten Schädigungskennwertes $LC_{PC}$ während des Betriebes der Halbleiterbaugruppe ergibt sich ebenfalls eine monoton ansteigende Funktion, die bei Erreichen der maximalen Lebensdauer den Wert 1 annimmt, die aber steiler oder flacher als jene des ersten Referenzwertes $LC_{PC,ref}$ sein kann. Falls sie steiler ist, wird der entsprechende Umrichter stärker als erwartet belastet, sodass mit einem frühzeitigen Ausfall der Halbleiterbaugruppe zu rechnen ist. Falls sie flacher ist, wird der entsprechende Umrichter weniger als erwartet belastet, sodass mit einem sicheren Betrieb der Halbleiterbaugruppe bis zur erwarteten Höchstlebensdauer zu rechnen ist.

Zur Ermittlung des zweiten Schädigungskennwertes $LC_{TC}$ wird eine analoge Vorgangsweise vorgeschlagen, indem die Auswertealgorithmen eine anhand des niederzyklischen Last-Zeitverlaufes durchgeführte Rainflow-Zählung umfassen, mittels der für die im Trägeraufbau auftretende Temperatur $T_C$ die Häufigkeit eines Temperaturhubes $\Delta T_C$ einer bestimmten Größenordnung für unterschiedliche Größenordnungen gezählt wird, sowie eine rechnerische Ermittlung der maximalen Anzahl an Belastungszyklen $N_{C,f}$ für einen Temperaturhub $\Delta T_C$ einer jeden Größenordnung, wobei es sich beim zweiten Schädigungskennwert $LC_{TC}$ um die Summe der Quotienten aus der Häufigkeit eines Temperaturhubes $\Delta T_C$ einer bestimmten Größenordnung für die im Trägeraufbau auftretende Temperatur $T_C$ zur maximalen Anzahl an Belastungszyklen $N_{C,f}$ für einen Temperaturhub $\Delta T_C$ derselben Größenordnung handelt.

Zur Ermittlung der maximalen Anzahl an Belastungszyklen $N_{C,f}$ für den Temperaturhub $\Delta T_C$ einer jeden Größenordnung kann wiederum zunächst aus dem Temperaturhub $\Delta T_C$ einer bestimmten Größenordnung für die im Trägeraufbau auftretende Temperatur $T_C$ ein Mittelwert $T_{C,m}$ für die im Trägeraufbau auftretende Temperatur $T_C$ für die betreffende Größenordnung ermittelt werden, und die rechnerische Ermittlung der maximalen Anzahl an Belastungszyklen $N_{C,f}$ für den Temperaturhub $\Delta T_C$ einer jeden Größenordnung gemäß der folgenden Formel errechnet werden:

$$N_{C,f} = B \cdot \Delta T_C{}^{\beta} \cdot \exp(d/(k_B \cdot T_{C,m}))$$

wobei es sich bei B, d und $\beta$ um für die betreffende Halbleiterbaugruppe empirisch oder mittels Simulation bestimmte Parameter handelt und $k_B = 1.38 \cdot 10^{-23}$ J/K ist.

Zur Ermittlung des zweiten Referenzwertes $LC_{TC,ref}$ für den zweiten Schädigungskennwert $LC_{TC}$ kann in analoger Weise zum ersten Referenzwert $LC_{PC,ref}$ vorgegangen werden, wobei jedoch ein erwarteter niederzyklischer Referenz-Last-Zeitverlauf herangezogen wird, und anhand des erwarteten niederzyklischen Referenz-Last-Zeitverlaufes eine Rainflow-Zählung durchgeführt wird, mittels der für die im Trägeraufbau auftretende Temperatur $T_{C,ref}$ die Häufigkeit eines Temperaturhubes $\Delta T_{C,ref}$ einer bestimmten Größenordnung für unterschiedliche Größenordnungen gezählt wird, sowie eine rechnerische Ermittlung der maximalen Anzahl an Belastungszyklen $N_{C,f,ref}$ für einen Temperaturhub $\Delta T_{C,ref}$ einer jeden Größenordnung, wobei es sich beim zweiten Referenzwert $LC_{TC,ref}$ um die Summe der Quotienten aus der Häufigkeit eines Temperaturhubes $\Delta T_{C,ref}$ einer bestimmten Größenordnung für die im Trägeraufbau auftretende Temperatur $T_{C,ref}$ zur maximalen Anzahl an Belastungszyklen $N_{C,f,ref}$ für einen Temperaturhub $\Delta T_{C,ref}$ derselben Größenordnung handelt.

Zur Ermittlung der maximalen Anzahl an Belastungszyklen $N_{C,f,ref}$ für den Temperaturhub $\Delta T_{C,ref}$ einer jeden Größenordnung kann wiederum aus dem Temperaturhub $\Delta T_{C,ref}$ einer bestimmten Größenordnung für die im Trägeraufbau auftretende Temperatur $T_{C,ref}$ ein Mittelwert $T_{C,m,ref}$ für die im Trägeraufbau auftretende Temperatur $T_{C,ref}$ für die betreffende Größenordnung ermittelt werden, und die rechnerische Ermittlung der maximalen Anzahl an Belastungszyklen $N_{C,f,ref}$ für den Temperaturhub $\Delta T_{C,ref}$ einer jeden Größenordnung gemäß der folgenden Formel errechnet werden:

$$N_{C,f,ref} = B \cdot \Delta T_{C,ref}{}^{\beta} \cdot \exp(d/(k_B \cdot T_{C,m,ref}))$$

wobei es sich bei B, d und $\beta$ um für die betreffende Halbleiterbaugruppe empirisch oder mittels Simulation bestimmte Parameter handelt und $k_B = 1.38 \cdot 10^{-23}$ J/K ist.

Diese Ermittlung des zweiten Referenzwertes $LC_{TC,ref}$ wird für einen bestimmten Anwendungsfall wiederum nur einmal vorgenommen werden, und zwar in der Regel seitens des Herstellers des Antriebsumrichters. Bei Berücksichtigung des zeitlichen Verlaufes des zweiten Referenzwertes $LC_{TC,ref}$ während des Betriebes der Halbleiterbaugruppe ergibt sich wiederum eine monoton ansteigende Funktion, die bei Erreichen der maximalen Lebensdauer den Wert 1 annimmt, und die im Speicher eines Mikroprozessors des Umrichters gespeichert ist. Die Ermittlung des zweiten Schädigungskennwertes $LC_{TC}$ wird hingegen während des Betriebes des Umrichters oftmals in vorgegebenen Zeitabständen anhand von aktuell ermittelten niederzyklischen Last-Zeitverläufen wiederholt und mit dem zweiten Referenzwert $LC_{TC,ref}$ verglichen, um ein Anzeigesignal zum aktuellen Schädigungszustand zu generieren. Bei Berücksichtigung des zeitlichen Verlaufes des zweiten Schädigungskennwertes $LC_{TC}$ während des Betriebes der Halbleiterbaugruppe ergibt sich ebenfalls eine monoton ansteigende Funktion, die bei Erreichen der maximalen Lebensdauer den Wert 1 annimmt, die aber steiler oder flacher als jene des zweiten Referenzwertes $LC_{TC,ref}$ sein kann. Falls sie steiler ist, wird der entsprechende Umrichter stärker als erwartet belastet, sodass mit einem frühzeitigen Ausfall der Halbleiterbaugruppe zu rechnen ist. Falls sie unterhalb der Referenzkurve liegt, wird der entsprechende Umrichter weniger als erwartet belastet, sodass mit einem sicheren Betrieb der Halbleiterbaugruppe bis zur erwarteten Höchstlebensdauer zu rechnen ist.

Die Erfindung wird im Folgenden anhand von Ausführungsbeispielen mithilfe der beiliegenden Figuren näher erläutert. Hierbei zeigen die

Fig. 1 eine schematische Darstellung einer möglichen Ausführungsform einer Halbleiterbaugruppe,

Fig. 2 eine schematische Darstellung zur Illustration der Belastungszyklen im Zuge der thermischen Beanspruchung von Halbleiterbauelementen und Trägeraufbau während des Betriebes der Halbleiterbaugruppe, und die

Fig. 3 eine Blockdarstellung zur Illustration einer Ausführungsform des erfindungsgemäßen Verfahrens.

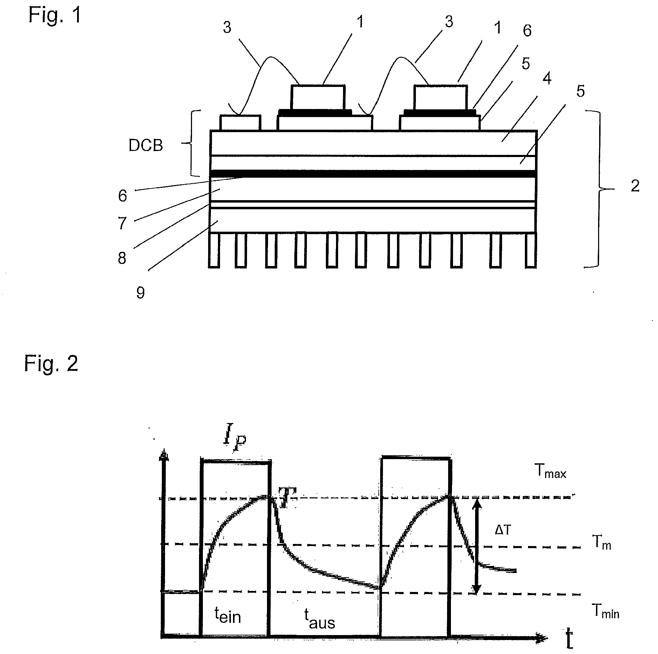

Zunächst wird auf die Fig. 1 Bezug genommen, die eine schematische Darstellung einer möglichen Ausführungsform einer Halbleiterbaugruppe mit einem Halbleiterbauelement 1 und einem Trägeraufbau 2 zeigt. Der Trägeraufbau 2 umfasst im gezeigten Ausführungsbeispiel ein DCB-Substrat, auf dem die Halbleiterbauelemente 1 in Form ungehäuster Chips ("bare dies") befestigt und mit Bond-Drähten 3 verbunden sind. DCB-Substrate bestehen aus einem keramischen Isolator 4, beispielsweise Aluminiumoxid oder Aluminiumnitrid, auf den in einem Hochtemperaturschmelz- und Diffusionsverfahren eine Kupferbeschichtung 5 aufgebracht und haftfest mit dem keramischen Isolator 4 verbunden wird. DCB-Substrate zeigen eine hohe Strombelastbarkeit aufgrund der dicken Kupfermetallisierung und werden insbesondere in Hochleistungs-Halbleitermodulen gerne verwendet. Die Halbleiterbauelemente 1 sind an einer Seite des keramischen Isolators 4 über Lötstellen 6 an der Kupferbeschichtung 5 befestigt. Auf der den Halbleiterbauelementen 1 entgegengesetzten Seite ist über weitere Lötstellen 6 eine Bodenplatte 7 an der Kupferbeschichtung 5 des keramischen Isolators 4 befestigt, die über eine thermische Schnittstelle 8 mit einem Kühlkörper 9 verbunden ist. Wie aus dem Aufbau gemäß der Fig. 1 ersichtlich ist, werden Halbleiterbaugruppen aus Materialien mit verschiedenen thermischen Eigenschaften, insbesondere verschiedenen thermischen Ausdehnungskoeffizienten, hergestellt. Daher kann es aufgrund der zeitlich veränderlichen Belastung zu mechanischen Spannungszuständen kommen, die die Halbleiterbaugruppe belasten. Eine zyklische thermische Belastung kann folglich mechanische Beschädigungen, wie etwa Schichtablösung, Ablösung von Anschlüssen oder Ermüdungsbrüche bewirken. Ein Ausfall des Halbleiterbauelements 1 kann beispielsweise durch Beschädigung des Halbleiters selbst, aber auch durch das Ablösen der Bond-Drähte 3 verursacht werden, oder durch Beschädigung der Lötstellen 6 des Halbleiterbauelements 1 am Trägeraufbau 2. Ein Ausfall des Trägeraufbaus 2 kann beispielsweise durch Beschädigung der Lötstellen 6 innerhalb des Trägeraufbaus oder durch Beschädigung der thermischen Schnittstelle 8 zwischen der Bodenplatte 7 und dem Kühlkörper 9 verursacht werden.

Die thermischen Belastungen der Halbleiterbaugruppe zeigen während des Betriebes eine zeitliche Periodizität, die auf die zeitlichen Änderungen der elektrischen Last $I_P$ zurückzuführen sind und im Falle eines Antriebsumrichters auch auf die Drehzahl der Maschine. Diese Belastungszyklen der thermischen Belastung werden anhand der Fig. 2 erläutert. Während der elektrischen Belastung ("$t_{on}$") steigt die Temperatur T an und erreicht bei Beendigung der elektrischen Belastung eine Maximaltemperatur $T_{max}$. Die Temperatur T wird in weiterer Folge wieder abnehmen ("$t_{off}$") und erreicht vor Beginn der neuerlichen Belastung einen Minimalwert $T_{min}$. Die Differenz ist der Temperaturhub $\Delta T$. Des Weiteren kann auch ein Mittelwert $T_m$ gebildet werden.

Im Rahmen der vorliegenden Erfindung werden diese Belastungszyklen für zwei unterschiedliche Temperaturen betrachtet, bei denen sich Änderungen unterschiedlich rasch vollziehen, nämlich in Form sich vergleichsweise rasch verändernder hochzyklischer Last-Zeitverläufe für eine innerhalb des Halbleiterbauelements 1 auftretende Temperatur $T_j$ und in Form sich vergleichsweise langsam verändernder niederzyklischer Last-Zeitverläufe für eine im Trägeraufbau 2 auftretende Temperatur $T_C$. Bei der innerhalb des Halbleiterbauelements 1 auftretenden Temperatur $T_j$ handelt es sich in der Regel um eine Sperrschichttemperatur, und bei der im Trägeraufbau 2 auftretenden Temperatur $T_C$ beispielsweise um eine an der Bodenplatte 7 des Trägeraufbaus 2 gemessene Temperatur.

Die an der Bodenplatte 7 des Trägeraufbaus 2 gemessene Temperatur $T_C$ kann leicht gemessen und in Form von niederzyklischen Last-Zeitverläufen angegeben werden, wie sie vereinfacht in der Fig. 2 dargestellt sind. Freilich sind tatsächliche Last-Zeitverläufe komplexer aufgebaut und zeigen beispielsweise eine Überlagerung mehrerer Belastungszyklen mit jeweils unterschiedlichem Temperaturhub und unterschiedlichen Perioden.

Die Sperrschichttemperatur als eine innerhalb des Halbleiterbauelements 1 auftretende Temperatur $T_j$ ist keiner

unmittelbaren Temperaturmessung zugänglich. Es kann allerdings andernorts eine für die Sperrschichttemperatur möglichst repräsentative Temperatur gemessen werden, um in weiterer Folge auf die Sperrschichttemperatur rückschließen zu können. Hierfür kann sich der Anwender auf unterschiedliche thermische Modelle stützen. So existieren beispielsweise detaillierte thermische Modelle, die mit der Schaltfrequenz, also mit einer Updaterate von mehreren kHz, neu berechnet werden. Auch vereinfachte thermische Modelle mit geringeren Updateraten sind verfügbar, die freilich auch geringere Genauigkeiten besitzen.

Eine weitere Möglichkeit wurde in der AT 518.115 der Anmelderin beschrieben. Hierbei wird in einem ersten Schritt aus Schaltungsparametern $S_i$ (i=1,2...N) eine über die Stromperiode gemittelte Verlustleistung errechnet, und aus der Verlustleistung mithilfe an sich bekannter thermischer Simulationsmodelle ein über die Stromperiode gemittelter Durchschnittswert der thermischen Belastung ermittelt. In einem zweiten Schritt wird aus vorgegebenen Interpolationsfunktionen für die Schaltungsparameter $S_i$ ein Korrekturwert für den über die Stromperiode gemittelten Durchschnittswert der thermischen Belastung zu einem Maximalwert der thermischen Belastung während der Stromperiode ermittelt, wobei der Maximalwert der thermischen Belastung die Summe oder das Produkt des über die Stromperiode gemittelten Durchschnittswerts der thermischen Belastung und des Korrekturwerts ist. Die Verlustleistung kann aus den über eine Stromperiode im Wesentlichen zeitunabhängigen Schaltungsparametern $S_i$ ermittelt werden. Zur Erstellung der genannten Interpolationsfunktionen können mithilfe an sich bekannter thermischer Simulationsmodelle für Kombinationen zu erwartender Schaltungsparameter $S_i$ die maximale Abweichung der thermischen Belastung vom Mittelwert punktweise errechnet und durch Vergleich mit dem Mittelwert ein Korrekturwert ermittelt werden, wobei ausgewählte Korrekturwerte für ausgewählte Kombinationen der Schaltungsparameter $S_i$ die Stützpunkte der Interpolationsfunktionen sind. Mithilfe dieses Verfahrens kann einerseits die Genauigkeit von an sich bekannten thermischen Simulationsmodellen weitest gehend beibehalten werden, wobei allerdings die Notwendigkeit hoher Rechenleistungen während des Betriebes der Schaltung vermieden wird. Stattdessen sind während des Betriebes der Schaltung lediglich die Verlustleistung aus im Wesentlichen zeitunabhängigen Mittelwerten der Schaltungsparameter $S_i$, sowie in weiterer Folge ein Mittelwert der thermischen Belastung zu errechnen, wobei es sich dabei um vergleichsweise einfache Rechenoperationen handelt. Für eine hinreichend genaue Abschätzung der thermischen Belastung sind allerdings auch die oben erwähnten Wechselbelastungen zu berücksichtigen. Diese Wechselbelastungen werden im Rahmen der vorgeschlagenen Methodik mithilfe von Interpolationsfunktionen erfasst, die vorher (off-line) für jeden für die Wechselbelastung relevanten Schaltungsparameter $S_i$ bestimmt wurden und für jedes Halbleiterbauelement in einer Speichereinheit eines entsprechenden Prozessors, der bei Leistungsschaltungen in der Regel ohnehin vorgesehen ist, abgespeichert sind. Dabei wird aber die Wechselbelastung nicht in ihrer Zeitabhängigkeit nachvollzogen, sondern lediglich ausgehend von einem Mittelwert ein Korrekturwert zur Berechnung des Maximalwerts ermittelt, indem mithilfe an sich bekannter thermischer Simulationsmodelle für Kombinationen zu erwartender Schaltungsparameter $S_i$ die maximale (positive) Abweichung der thermischen Belastung vom Mittelwert punktweise errechnet und als Stützwerte einer Interpolationsfunktion in Bibliotheken bereit gestellt wird. Während des Betriebes der Schaltung wird für konkrete Schaltungsparameter $S_i$ mithilfe dieser Interpolationsfunktionen der Korrekturwert zur Berechnung des Maximalwerts ermittelt. Auch dieser Vorgang kann vergleichsweise rasch und ohne große Rechenleistung während des Betriebes der Schaltung erfolgen. Aufgrund des geringen Rechenaufwandes während des Betriebes der Schaltung besteht mithilfe der vorgeschlagenen Methodik auch die Möglichkeit, die thermische Belastung eines jeden Halbleiterbauelements 1 auch während des Betriebes oftmals zu bestimmen.

Das Ergebnis dieser Berechnungen lässt sich in hochzyklischen Last-Zeitverläufen darstellen, wie sie vereinfacht in der Fig. 2 dargestellt sind. Freilich sind tatsächliche Last-Zeitverläufe komplexer aufgebaut und zeigen beispielsweise eine Überlagerung mehrerer Belastungszyklen mit jeweils unterschiedlichem Temperaturhub und unterschiedlichen Perioden.

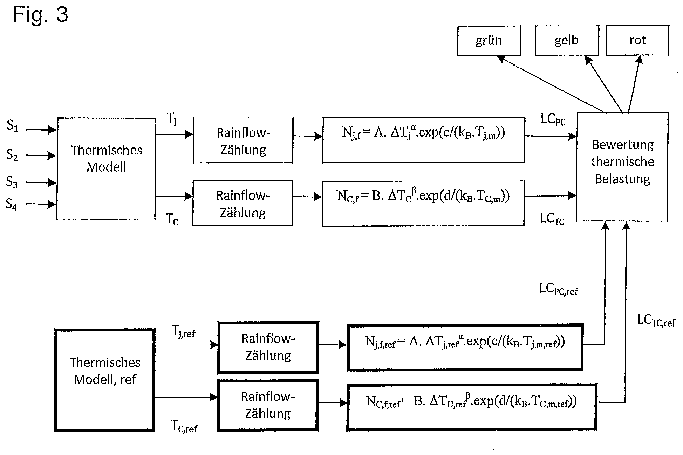

Der so ermittelte hochzyklische Last-Zeitverlauf für eine innerhalb des Halbleiterbauelements 1 auftretende Temperatur $T_j$ und der niederzyklische Last-Zeitverlauf für eine im Trägeraufbau 2 auftretende Temperatur $T_C$ sind Ausgangspunkt des erfindungsgemäßen Verfahrens, wie in weiterer Folge anhand der Fig. 3 erläutert wird. Die Ermittlung der hochzyklischen und niederzyklischen Last-Zeitverläufe findet dabei in dem mit "Thermisches Modell" bezeichneten, ersten Block der Fig. 3 statt.

Diese Last-Zeitverläufe werden jeweils einer Rainflow-Zählung unterworfen. Beim hochzyklischen Last-Zeiverlauf wird mittels der Rainflow-Zählung für die innerhalb des Halbleiterbauelements auftretende Temperatur $T_j$ die Häufigkeit eines Temperaturhubes $\Delta T_j$ einer bestimmten Größenordnung für unterschiedliche Größenordnungen gezählt. Das Ergebnis ist eine Matrix, bei der unterschiedlichen Größenordnungen für den Temperaturhub $\Delta T_j$ eine entsprechende Häufigkeit zugeordnet wird. Die hochzyklischen Last-Zeitverläufe werden in vorgegebenen Abständen während des Betriebes der Halbleiterbaugruppe ermittelt und analysiert, wobei die Häufigkeiten eines Temperaturhubes $\Delta T_j$ einer bestimmten Größenordnung über die Zeit aufsummiert werden. Die so ermittelten Häufigkeiten können in Relation zur maximalen Anzahl an Belastungszyklen $N_{j,f}$ für einen Temperaturhub $\Delta T_j$ einer bestimmten Größenordnung gesetzt werden. Dieser Quotient, der für jede Größenordnung ermittelt werden kann, kann in weiterer Folge über alle Größenordnungen aufsummiert werden und ergibt einen Wert, der zu Beginn des Betriebes der Halbleiterbaugruppe klein sein wird und sich während der Laufzeit der Halbleiterbaugruppe dem Wert 1 annähern wird. Dieser Wert ist der erste Schädigungskennwert LC$_{PC}$.

Für die rechnerische Ermittlung der maximalen Anzahl an Belastungszyklen N$_{j,f}$ für den Temperaturhub ΔT$_j$ einer bestimmten Größenordnung kann zunächst aus dem Temperaturhub ΔT$_j$ einer bestimmten Größenordnung für die innerhalb des Halbleiterbauelements auftretende Temperatur T$_j$ zunächst ein Mittelwert T$_{j,m}$ für die innerhalb des Halbleiterbauelements auftretende Temperatur T$_j$ für die betreffende Größenordnung ermittelt werden. Die rechnerische Ermittlung der maximalen Anzahl an Belastungszyklen N$_{j,f}$ für den Temperaturhub ΔT$_j$ einer jeden Größenordnung kann in weiterer Folge gemäß der folgenden Formel errechnet werden:

$$N_{j,f} = A \cdot \Delta T_j^{\alpha} \cdot \exp(c/(k_B \cdot T_{j,m}))$$

wobei es sich bei A, c und α um empirisch oder mittels Simulation für die betreffende Halbleiterbaugruppe bestimmte Parameter handelt und k$_B$=1.38.10$^{-23}$ J/K ist.

In analoger Weise kann beim niederzyklischen Last-Zeitverlauf vorgegangen werden. Beim niederzyklischen Last-Zeiverlauf wird mittels der Rainflow-Zählung für die Temperatur T$_C$ der Bodenplatte 7 die Häufigkeit eines Temperaturhubes ΔT$_C$ einer bestimmten Größenordnung für unterschiedliche Größenordnungen gezählt. Das Ergebnis ist wiederum eine Matrix, bei der unterschiedlichen Größenordnungen für den Temperaturhub ΔT$_C$ eine entsprechende Häufigkeit zugeordnet wird. Die niederzyklischen Last-Zeitverläufe werden in vorgegebenen Abständen während des Betriebes der Halbleiterbaugruppe ermittelt und analysiert, wobei die Häufigkeiten eines Temperaturhubes ΔT$_C$ einer bestimmten Größenordnung über die Zeit aufsummiert werden. Die so ermittelten Häufigkeiten können in Relation zur maximalen Anzahl an Belastungszyklen N$_{C,f}$ für einen Temperaturhub ΔT$_C$ einer bestimmten Größenordnung gesetzt werden. Dieser Quotient, der für jede Größenordnung ermittelt werden kann, kann in weiterer Folge über alle Größenordnungen aufsummiert werden und ergibt einen Wert, der zu Beginn des Betriebes der Halbleiterbaugruppe klein sein wird und sich während der Laufzeit der Halbleiterbaugruppe dem Wert 1 annähern wird. Dieser Wert ist der zweite Schädigungskennwert LC$_{TC}$,

Für die rechnerische Ermittlung der maximalen Anzahl an Belastungszyklen N$_{C,f}$ für den Temperaturhub ΔT$_C$ einer bestimmten Größenordnung kann zunächst aus dem Temperaturhub ΔT$_C$ einer bestimmten Größenordnung für die Temperatur T$_C$ der Bodenplatte 7 zunächst ein Mittelwert T$_{C,m}$ für die betreffende Größenordnung ermittelt werden. Die rechnerische Ermittlung der maximalen Anzahl an Belastungszyklen N$_{C,f}$ für den Temperaturhub ΔT$_C$ einer jeden Größenordnung kann in weiterer Folge gemäß der folgenden Formel errechnet werden:

$$N_{C,f} = B \cdot \Delta T_C^{\beta} \cdot \exp(d/(k_B \cdot T_{C,m}))$$

wobei es sich bei B, d und β um für die betreffende Halbleiterbaugruppe empirisch oder mittels Simulation bestimmte Parameter handelt und k$_B$=1.38.10$^{-23}$ J/K ist.

Die Ermittlung des ersten Referenzwertes LC$_{PC,ref}$ und des zweiten Referenzwertes LC$_{TC,ref}$ wird in analoger Weise wie die Ermittlung des ersten Schädigungskennwertes LC$_{PC}$ und des zweiten Schädigungskennwertes LC$_{TC}$ vorgenommen, wie anhand des unteren Teils der Fig. 3 mit den fett umrandeten Blöcken gezeigt ist. Es wird lediglich ein erwarteter hochzyklischer oder niederzyklischer Referenz-Last-Zeitverlauf herangezogen, und anhand des erwarteten hochzyklischen oder niederzyklischen Referenz-Last-Zeitverlaufes eine Rainflow-Zählung durchgeführt. Die Ermittlung des ersten Referenzwertes LC$_{PC,ref}$ und des zweiten Referenzwertes LC$_{TC,ref}$ wird für einen bestimmten Anwendungsfall zudem nur einmal vorgenommen werden, und zwar in der Regel seitens des Herstellers des Antriebsumrichters. Bei Berücksichtigung des zeitlichen Verlaufes der Referenzwerte LC$_{PC,ref}$ und LC$_{TC,ref}$ während des Betriebes der Halbleiterbaugruppe ergibt sich jeweils eine monoton ansteigende Funktion, die bei Erreichen der maximalen Lebensdauer den Wert 1 annimmt, und die im Speicher eines Mikroprozessors des Umrichters gespeichert ist. Die Ermittlung des ersten Schädigungskennwertes LC$_{PC}$ und des zweiten Schädigungskennwertes LC$_{TC}$ wird hingegen während des Betriebes des Umrichters oftmals in vorgegebenen Zeitabständen anhand von aktuell ermittelten Last-Zeitverläufen wiederholt und mit dem ersten Referenzwert LC$_{PC,ref}$ und dem zweiten Referenzwert LC$_{TC,ref}$ verglichen, um ein Anzeigesignal zum aktuellen Belastungszustand zu generieren. Bei Berücksichtigung des zeitlichen Verlaufes des ersten Schädigungskennwertes LC$_{PC}$ und des zweiten Schädigungskennwertes LC$_{TC}$ während des Betriebes der Halbleiterbaugruppe ergibt sich jeweils eine monoton ansteigende Funktion, die bei Erreichen der maximalen Lebensdauer den Wert 1 annimmt, die aber steiler oder flacher als jene der entsprechenden Referenzwerte LC$_{PC,ref}$, LC$_{TC,ref}$ sein kann. Falls sie steiler ist, wird der entsprechende Umrichter stärker als erwartet belastet, sodass mit einem frühzeitigen Ausfall der Halbleiterbaugruppe zu rechnen ist. Falls sie flacher ist, wird der entsprechende Umrichter weniger als erwartet belastet, sodass mit einem sicheren Betrieb der Halbleiterbaugruppe bis zur erwarteten Höchstlebensdauer zu rechnen ist.

Dabei kann der absolute Wert verglichen werden, oder die zeitliche Ableitung, was dem Anstieg der genannten monotonen Funktionen entspricht. Sowohl der absolute Wert als auch die zeitliche Ableitung eignen sich für einen Vergleich des ersten und zweiten Schädigungskennwertes $LC_{PC}$, $LC_{TC}$ mit den jeweiligen Referenzwerten $LC_{PC,ref}$, $LC_{TC,ref}$.

Anhand dieses Vergleiches erfolgt die Zuordnung zu einem unkritischen, einem kritischen und einem überkritischen Betriebszustandsbereich durch Vergleich des ersten Schädigungskennwertes $LC_{PC}$ mit dem ersten Referenzwert $LC_{PC,ref}$ und des zweiten Schädigungskennwertes $LC_{TC}$ mit dem zweiten Referenzwert $LC_{TC,ref}$, wobei ein unkritischer Betriebszustandsbereich jeweils dann vorliegt, falls der jeweilige Schädigungskennwert $LC_{PC}$, $LC_{TC}$ unterhalb eines Abweichungsbereiches des ihm jeweils zugeordneten Referenzwertes $LC_{PC,ref}$ $LC_{TC,ref}$ liegt. Ein kritischer Betriebszustandsbereich liegt jeweils dann vor, falls der Schädigungskennwert $LC_{PC}$, $LC_{TC}$ innerhalb des Abweichungsbereiches des ihm jeweils zugeordneten Referenzwertes $LC_{PC,ref}$, $LC_{TC,ref}$ liegt, und ein überkritischer Betriebszustandsbereich liegt jeweils dann vor, falls der Schädigungskennwert $LC_{PC}$, $LC_{TC}$ oberhalb des Abweichungsbereiches des ihm jeweils zugeordneten Referenzwertes $LC_{PC,ref}$, $LC_{TC,ref}$ liegt. Der Abweichungsbereich der Referenzwerte $LC_{PC,ref}$, $LC_{TC,ref}$ kann beispielsweise im Wertebereich von 80-100% der Referenzwerte $LC_{PC,ref}$, $LC_{TC,ref}$ liegen. Ein unkritischer Betriebszustandsbereich würde in diesem Fall dann vorliegen, falls beispielsweise der erste Schädigungskennwert $LC_{PC}$ weniger als 80% des ersten Referenzwertes $LC_{PC,ref}$ beträgt. Ein kritischer Betriebszustandsbereich würde dann vorliegen, falls der erste Schädigungskennwert $LC_{PC}$ innerhalb des Abweichungsbereiches von 80-100% des ersten Referenzwertes $LC_{PC,ref}$ liegt. Ein überkritischer Betriebszustandsbereich würde dann vorliegen, falls der erste Schädigungskennwert $LC_{PC}$ oberhalb des ersten Referenzwertes $LC_{PC,ref}$ liegt. Letzteres stellt eine unerwartet starke Belastung der Halbleiterbaugruppe dar, über die der Anwender Bescheid wissen sollte, um in geeigneter Weise intervenieren zu können. Freilich können die unkritischen, kritischen und überkritischen Betriebszustandsbereiche auch in Form anderer Prozentabweichungen für den Abweichungsbereich gewählt werden, zudem könnten für hochzyklische und niederzyklische Belastungen jeweils unterschiedliche Prozentabweichungen zur Festlegung der unkritischen, kritischen und überkritischen Betriebszustandsbereiche gewählt werden.

Mithilfe der Erfindung ist es somit möglich den thermischen Schädigungszustand einer betrieblich belasteten Halbleiterbaugruppe zu bewerten, wobei es nicht nur möglich ist eine verbrauchte Lebensdauer für die gesamte Halbleiterbaugruppe abzuschätzen, sondern auch unerwartete oder unerwünschte Belastungszustände und somit eine vorschnelle Minderung der verbleibenden Lebensdauer der Halbleiterbaugruppe zu detektieren. Dadurch werden bereits während des Betriebes der Halbleiterbaugruppe laufende Belastungsevaluierungen ermöglicht, die zeitgerechte Interventionen erlauben.

**Patentansprüche**

1. Verfahren zur Bewertung des Schädigungszustandes einer betrieblich belasteten Halbleiterbaugruppe, insbesondere eines Antriebsumrichters, mit zumindest einem auf oder in einem Trägeraufbau (2) angeordneten Halbleiterbauelement (1), wobei eine innerhalb des Halbleiterbauelements (1) auftretende Temperatur ($T_j$) in Form einer Zeitreihe als hochzyklischer Last-Zeit-Verlauf ermittelt wird, dem mithilfe an sich bekannter Auswertealgorithmen ein erster Schädigungskennwert ($LC_{PC}$) zugeordnet wird, und eine im Trägeraufbau (2) auftretende Temperatur ($T_C$) in Form einer Zeitreihe als niederzyklischer Last-Zeit-Verlauf ermittelt wird, dem mithilfe der an sich bekannten Auswertealgorithmen ein zweiter Schädigungskennwert ($LC_{TC}$) zugeordnet wird, wobei es sich bei dem hochzyklischen Last-Zeit-Verlauf und dem niederzyklischen Last-Zeit-Verlauf jeweils um zeitveränderliche thermische Belastungen handelt, deren Schwingzyklen unterschiedlich rasch verlaufen, wobei die Schwingzyklen der hochzyklischen Belastungen rascher verlaufen als jene der niederzyklischen Belastungen, **dadurch gekennzeichnet, dass** der erste Schädigungskennwert ($LC_{PC}$) zur Identifizierung eines hochzyklischen Ist-Betriebszustandsbereiches der Halbleiterbaugruppe durch Vergleich des ersten Schädigungskennwertes ($LC_{PC}$) mit einem vorgegebenen ersten Referenzwert ($LC_{PC,ref}$) einem unkritischen, einem kritischen und einem überkritischen Betriebszustandsbereich für hochzyklische Belastungen der Halbleiterbaugruppe zugeordnet wird, und der zweite Schädigungskennwert ($LC_{TC}$) zur Identifizierung eines niederzyklischen Ist-Betriebszustandsbereiches der Halbleiterbaugruppe durch Vergleich des zweiten Schädigungskennwertes ($LC_{TC}$) mit einem vorgegebenen zweiten Referenzwert ($LC_{TC,ref}$) einem unkritischen, einem kritischen und einem überkritischen Betriebszustandsbereich für niederzyklische Belastungen der Halbleiterbaugruppe zugeordnet wird, und in weiterer Folge ein erstes Anzeigesignal generiert wird, falls sowohl der hochzyklische als auch der niederzyklische IST-Betriebszustandsbereich einem unkritischen Betriebszustandsbereich entsprechen, ein zweites Anzeigesignal generiert wird, falls der hochzyklische oder der niederzyklische IST-Betriebszustandsbereich einem kritischen Betriebszustandsbereich und beide keinem überkritischen Betriebszustandsbereich entsprechen, und ein drittes Anzeigesignal generiert wird, falls der hochzyklische oder der niederzyklische IST-Betriebszustandsbereich einem überkritischen Betriebszustandsbereich entspricht, wobei

- ) es sich beim zeitlichen Verlauf des ersten Referenzwertes (LC$_{PC,ref}$) sowie des zweiten Referenzwertes (LC$_{TC,ref}$) während des Betriebes der Halbleiterbaugruppe jeweils um eine vorgegebene, monoton ansteigende Funktion handelt, die bei Erreichen der maximalen Lebensdauer den Wert 1 annimmt, und

- ) die Ermittlung des ersten Schädigungskennwertes (LC$_{PC}$) während des Betriebes des Umrichters oftmals in vorgegebenen Zeitabständen anhand von aktuell ermittelten hochzyklischen Last-Zeitverläufen wiederholt und mit dem ersten Referenzwert (LC$_{PC,ref}$) verglichen wird, und

- ) die Ermittlung des zweiten Schädigungskennwertes (LC$_{TC}$) während des Betriebes des Umrichters oftmals in vorgegebenen Zeitabständen anhand von aktuell ermittelten niederzyklischen Last-Zeitverläufen wiederholt und mit dem zweiten Referenzwert (LC$_{TC,ref}$) verglichen wird, um jeweils ein Anzeigesignal zum aktuellen Belastungszustand zu generieren.

2. Verfahren nach Anspruch 1, **dadurch gekennzeichnet, dass** ein unkritischer Betriebszustandsbereich jeweils dann vorliegt, falls der Schädigungskennwert (LC$_{PC}$, LC$_{TC}$) unterhalb eines Abweichungsbereiches des ihm zugeordneten Referenzwertes (LC$_{PC,ref}$, LC$_{TC,ref}$) liegt, ein kritischer Betriebszustandsbereich jeweils dann vorliegt, falls der Schädigungskennwert (LC$_{PC}$, LC$_{TC}$) innerhalb des Abweichungsbereiches des ihm zugeordneten Referenzwertes (LC$_{PC,ref}$, LC$_{TC,ref}$) liegt, und ein überkritischer Betriebszustandsbereich jeweils dann vorliegt, falls der Schädigungskennwert (LC$_{PC}$, LC$_{TC}$) oberhalb des Abweichungsbereiches des ihm zugeordneten Referenzwertes (LC$_{PC,ref}$, LC$_{TC,ref}$) liegt.

3. Verfahren nach Anspruch 2, **dadurch gekennzeichnet, dass** der Abweichungsbereich der Referenzwerte (LC$_{PC,ref}$, LC$_{TC,ref}$) im Wertebereich von 80-100% der Referenzwerte (LC$_{PC,ref}$, LC$_{TC,ref}$) liegt.

4. Verfahren nach einem der Ansprüche 1 bis 3, **dadurch gekennzeichnet, dass** die Auswertealgorithmen eine anhand des hochzyklischen Last-Zeitverlaufes durchgeführte Rainflow-Zählung umfassen, mittels der für die innerhalb des Halbleiterbauelements auftretende Temperatur (T$_j$) die Häufigkeit eines Temperaturhubes (ΔT$_j$) einer bestimmten Größenordnung für unterschiedliche Größenordnungen gezählt wird, sowie eine rechnerische Ermittlung der maximalen Anzahl an Belastungszyklen (N$_{j,f}$) für einen Temperaturhub (ΔT$_j$) einer jeden Größenordnung, wobei es sich beim ersten Schädigungskennwert (LC$_{PC}$) um die Summe der Quotienten aus der Häufigkeit eines Temperaturhubes (ΔT$_j$) einer bestimmten Größenordnung für die innerhalb des Halbleiterbauelements auftretende Temperatur (T$_j$) zur maximalen Anzahl an Belastungszyklen (N$_{j,f}$) für einen Temperaturhub (ΔT$_j$) derselben Größenordnung handelt.

5. Verfahren nach Anspruch 4, **dadurch gekennzeichnet, dass** aus dem Temperaturhub (ΔT$_j$) einer bestimmten Größenordnung für die innerhalb des Halbleiterbauelements auftretende Temperatur (T$_j$) ein Mittelwert (T$_{j,m}$) für die innerhalb des Halbleiterbauelements auftretende Temperatur (T$_j$) für die betreffende Größenordnung ermittelt wird, und die rechnerische Ermittlung der maximalen Anzahl an Belastungszyklen (N$_{j,f}$) für den Temperaturhub (ΔT$_j$) einer jeden Größenordnung gemäß der folgenden Formel errechnet wird:

$$N_{j,f} = A \cdot \Delta T_j^{\alpha} \cdot \exp(c/(k_B \cdot T_{j,m}))$$

wobei es sich bei A, c und α um empirisch oder mittels Simulation für die betreffende Halbleiterbaugruppe bestimmte Parameter handelt und k$_B$=1.38.10$^{-23}$ J/K ist.

6. Verfahren nach einem der Ansprüche 1 bis 5, **dadurch gekennzeichnet, dass** anhand eines erwarteten hochzyklischen Referenz-Last-Zeitverlaufes eine Rainflow-Zählung durchgeführt wird, mittels der für die innerhalb des Halbleiterbauelements auftretende Temperatur (T$_{j,ref}$) die Häufigkeit eines Temperaturhubes (ΔT$_{j,ref}$) einer bestimmten Größenordnung für unterschiedliche Größenordnungen gezählt wird, sowie eine rechnerische Ermittlung der maximalen Anzahl an Belastungszyklen (N$_{j,f,ref}$) für einen Temperaturhub (ΔT$_{j,ref}$) einer jeden Größenordnung, wobei es sich beim ersten Referenzwert (LC$_{PC,ref}$) um die Summe der Quotienten aus der Häufigkeit eines Temperaturhubes (ΔT$_{j,ref}$) einer bestimmten Größenordnung für die innerhalb des Halbleiterbauelements auftretende Temperatur (T$_{j,ref}$) zur maximalen Anzahl an Belastungszyklen (N$_{j,f,ref}$) für einen Temperaturhub (ΔT$_{j,ref}$) derselben Größenordnung handelt.

7. Verfahren nach Anspruch 6, **dadurch gekennzeichnet, dass** aus dem Temperaturhub (ΔT$_{j,ref}$) einer bestimmten Größenordnung für die innerhalb des Halbleiterbauelements auftretende Temperatur (T$_{j,ref}$) ein Mittelwert (T$_{j,m,ref}$) für die innerhalb des Halbleiterbauelements auftretende Temperatur (T$_{j,ref}$) für die betreffende Größenordnung ermittelt wird, und die rechnerische Ermittlung der maximalen Anzahl an Belastungszyklen (N$_{j,f,ref}$) für den Tempe-

raturhub ($\Delta T_{j,ref}$) einer jeden Größenordnung gemäß der folgenden Formel errechnet wird:

$$N_{j,f,ref} = A. \ \Delta T_{j,ref}^{\alpha}.\exp(c/(k_B.T_{j,m,ref}))$$

wobei es sich bei A, c und $\alpha$ um empirisch oder mittels Simulation für die betreffende Halbleiterbaugruppe bestimmte Parameter handelt und $k_B$=1.38.10^{-23} J/K ist.

8. Verfahren nach einem der Ansprüche 1 bis 7, **dadurch gekennzeichnet, dass** die Auswertealgorithmen eine anhand des niederzyklischen Last-Zeitverlaufes durchgeführte Rainflow-Zählung umfassen, mittels der für die im Trägeraufbau (2) auftretende Temperatur ($T_C$) die Häufigkeit eines Temperaturhubes ($\Delta T_C$) einer bestimmten Größenordnung für unterschiedliche Größenordnungen gezählt wird, sowie eine rechnerische Ermittlung der maximalen Anzahl an Belastungszyklen ($N_{C,f}$) für einen Temperaturhub ($\Delta T_C$) einer jeden Größenordnung, wobei es sich beim zweiten Schädigungskennwert ($LC_{TC}$) um die Summe der Quotienten aus der Häufigkeit eines Temperaturhubes ($\Delta T_C$) einer bestimmten Größenordnung für die im Trägeraufbau (2) auftretende Temperatur ($T_C$) zur maximalen Anzahl an Belastungszyklen ($N_{C,f}$) für einen Temperaturhub ($\Delta T_C$) derselben Größenordnung handelt.

9. Verfahren nach Anspruch 8, **dadurch gekennzeichnet, dass** aus dem Temperaturhub ($\Delta T_C$) einer bestimmten Größenordnung für die im Trägeraufbau (2) auftretende Temperatur ($T_C$) ein Mittelwert ($T_{C,m}$) für die im Trägeraufbau (2) auftretende Temperatur ($T_C$) für die betreffende Größenordnung ermittelt wird, und die rechnerische Ermittlung der maximalen Anzahl an Belastungszyklen ($N_{C,f}$) für den Temperaturhub ($\Delta T_C$) einer jeden Größenordnung gemäß der folgenden Formel errechnet wird:

$$N_{C,f} = B. \ \Delta T_C^{\beta}.\exp(d/(k_B.T_{C,m}))$$

wobei es sich bei B, d und $\beta$ um für die betreffende Halbleiterbaugruppe empirisch oder mittels Simulation bestimmte Parameter handelt und $k_B$=1.38.10^{-23} J/K ist.

10. Verfahren nach einem der Ansprüche 1 bis 9, **dadurch gekennzeichnet, dass** anhand eines erwarteten niederzyklischen Referenz-Last-Zeitverlaufes eine Rainflow-Zählung durchgeführt wird, mittels der für die im Trägeraufbau (2) auftretende Temperatur ($T_{C,ref}$) die Häufigkeit eines Temperaturhubes ($\Delta T_{C,ref}$) einer bestimmten Größenordnung für unterschiedliche Größenordnungen gezählt wird, sowie eine rechnerische Ermittlung der maximalen Anzahl an Belastungszyklen ($N_{C,f,ref}$) für einen Temperaturhub ($\Delta T_{C,ref}$) einer jeden Größenordnung, wobei es sich beim zweiten Referenzwert ($LC_{TC,ref}$) um die Summe der Quotienten aus der Häufigkeit eines Temperaturhubes ($\Delta T_{C,ref}$) einer bestimmten Größenordnung für die im Trägeraufbau (2) auftretende Temperatur ($T_{C,ref}$) zur maximalen Anzahl an Belastungszyklen ($N_{C,f,ref}$) für einen Temperaturhub ($\Delta T_{C,ref}$) derselben Größenordnung handelt.

11. Verfahren nach Anspruch 10, **dadurch gekennzeichnet, dass** aus dem Temperaturhub ($\Delta T_{C,ref}$) einer bestimmten Größenordnung für die im Trägeraufbau (2) auftretende Temperatur ($T_{C,ref}$) ein Mittelwert ($T_{C,m,ref}$) für die im Trägeraufbau (2) auftretende Temperatur ($T_{C,ref}$) für die betreffende Größenordnung ermittelt wird, und die rechnerische Ermittlung der maximalen Anzahl an Belastungszyklen ($N_{C,f,ref}$) für den Temperaturhub ($\Delta T_{C,ref}$) einer jeden Größenordnung gemäß der folgenden Formel errechnet wird:

$$N_{C,f,ref} = B. \ \Delta T_{C,ref}^{\beta}.\exp(d/(k_B.T_{C,m,ref}))$$

wobei es sich bei B, d und $\beta$ um für die betreffende Halbleiterbaugruppe empirisch oder mittels Simulation bestimmte Parameter handelt und $k_B$=1.38.10^{-23} J/K ist.

12. Antriebsumrichter mit einem Prozessor eingerichtet zur Durchführung des Verfahrens nach einem der Ansprüche 1 bis 11.

**Claims**

1. Method for assessing the damage state of an operationally loaded semiconductor assembly, in particular a drive system converter, having at least one semiconductor component (1) arranged on or in a support structure (2),

wherein a temperature ($T_j$) occurring within the semiconductor component (1) is determined in the form of a time series as a high-cycle load-time curve, to which a first damage characteristic value ($LC_{PC}$) is assigned with the aid of assessment algorithms known per se, and a temperature (Tc) occurring in the support structure (2) is determined in the form of a time series as a low-cyclic load-time curve, to which a second damage characteristic value ($LC_{TC}$) is assigned with the aid of the assessment algorithms known per se, with the high-cycle load-time curve and the low-cyclic load-time curve being time-varying thermal loads whose oscillation cycles proceed at different rates, with the oscillation cycles of the high-cycle loads proceeding more rapidly than those of the low-cycle loads, **characterized in that** the first damage characteristic value ($LC_{PC}$) for identifying a high-cycle actual operating state range of the semiconductor assembly is assigned to a non-critical, a critical and a supercritical operating state range for high-cycle loads on the semiconductor assembly by comparison of the first damage characteristic value ($LC_{PC}$) with a predetermined first reference value ($LC_{PC,ref}$) and the second damage characteristic value ($LC_{TC}$) for identifying a low-cycle actual operating state range of the semiconductor assembly is assigned to a non-critical, a critical and a supercritical operating state range for low-cycle loads of the semiconductor assembly by comparison of the second damage characteristic value ($LC_{TC}$) with a predetermined second reference value ($LC_{TC,ref}$), and subsequently a first indication signal is generated if both the high-cycle and the low-cycle actual operating state ranges correspond to a non-critical operating state range, a second indication signal is generated if the high-cycle or the low-cycle actual operating state range corresponds to a critical operating state range and neither corresponds to a supercritical operating state range, and a third indication signal is generated if the high-cycle or the low-cycle actual operating state range corresponds to a supercritical operating state range, wherein

- ) the time curve of the first reference value ($LC_{PC,ref}$) and of the second reference value ($LC_{TC,ref}$) during operation of the semiconductor assembly is in each case a predetermined, monotonically increasing function which assumes the value 1 when the maximum service life is reached, and
- ) the determination of the first damage characteristic value ($LC_{PC}$) during operation of the converter is often repeated at predetermined time intervals on the basis of currently determined high-cycle load-time curves and compared with the first reference value ($LC_{PC,ref}$), and
- ) the determination of the second damage characteristic value ($LC_{TC}$) during operation of the converter is often repeated at predetermined time intervals on the basis of currently determined low-cycle load-time curves and compared with the second reference value ($LC_{TC,ref}$) in order to generate in each case an indication signal for the current load state.

2. Method according to claim 1, **characterized in that** a non-critical operating state range is present in each case if the damage characteristic value ($LC_{PC}$, $LC_{TC}$) lies below a deviation range of the reference value ($LC_{PC,ref}$, $LC_{TC,ref}$) assigned to it, a critical operating state range is present in each case if the damage characteristic value ($LC_{PC}$, $LC_{TC}$) lies within the deviation range of the reference value ($LC_{PC,ref}$, $LC_{TC,ref}$) assigned to it, and a supercritical operating state range is present in each case if the damage characteristic value ($LC_{PC}$, $LC_{TC}$) lies above the deviation range of the reference value ($LC_{PC,ref}$, $LC_{TC,ref}$) assigned to it.

3. Method according to claim 2, **characterized in that** the deviation range of the reference values ($LC_{PC,ref}$, $LC_{TC,ref}$) is in the value range of 80-100% of the reference values ($LC_{PC,ref}$, $LC_{TC,ref}$).

4. Method according to one of claims 1 to 3, **characterized in that** the assessment algorithms comprise a rainflow count carried out on the basis of the high-cycle load-time curve, by means of which the frequency of a temperature rise ($\Delta T_j$) of a specific order of magnitude is counted for different orders of magnitude for the temperature ($T_j$) occurring within the semiconductor component, and a computational determination of the maximum number of load cycles ($N_{j,f}$) for a temperature rise ($\Delta T_j$) of each order of magnitude, wherein the first damage characteristic value ($LC_{PC}$) is the sum of the quotients of the frequency of a temperature rise ($\Delta T_j$) of a specific order of magnitude for the temperature ($T_j$) occurring within the semiconductor component to the maximum number of load cycles ($N_{j,f}$) for a temperature rise ($\Delta T_j$) of the same order of magnitude.

5. Method according to claim 4, **characterized in that** an average value ($T_{j,m}$) for the temperature ($T_j$) occurring within the semiconductor component is determined from the temperature rise ($\Delta T_j$) of a specific order of magnitude for the temperature ($T_j$) occurring within the semiconductor component for the respective order of magnitude, and the computational determination of the maximum number of load cycles ($N_{j,f}$) for the temperature rise ($\Delta T_j$) of each order of magnitude is calculated according to the following formula:

$$N_{j,f} = A.\Delta T_j^a.\exp(c/(k_B.T_{j,m}))$$

wherein A, c and $\alpha$ are parameters determined empirically or by simulation for the respective semiconductor assembly and $k_B = 1.38.10^{-23}$ J/K.

6. Method according to one of the claims 1 to 5, **characterized in that** a rainflow count is carried out on the basis of an expected high-cycle reference load-time curve, by means of which the frequency of a temperature rise ($\Delta T_{j,ref}$) of a specific order of magnitude is counted for different orders of magnitude for the temperature ($T_{j,ref}$) occurring within the semiconductor component, and a computational determination of the maximum number of load cycles ($N_{j,f,ref}$) for a temperature rise ($\Delta T_{j,ref}$) of each order of magnitude, wherein the first reference value ($LC_{PC,ref}$) is the sum of the quotients of the frequency of a temperature rise ($\Delta T_{j,ref}$) of a specific order of magnitude for the temperature ($T_{j,ref}$) occurring within the semiconductor component to the maximum number of load cycles ($N_{j,f,ref}$) for a temperature rise ($\Delta T_{j,ref}$) of the same order of magnitude.

7. Method according to claim 6, **characterized in that** an average value ($T_{j,m,ref}$) for the temperature ($T_{j,ref}$) occurring within the semiconductor component is determined from the temperature rise ($\Delta T_{j,ref}$) of a specific order of magnitude for the temperature ($T_{j,ref}$) occurring within the semiconductor component for the respective order of magnitude, and the computational determination of the maximum number of load cycles ($N_{j,f,ref}$) for the temperature rise ($\Delta T_{j,ref}$) of each order of magnitude is calculated according to the following formula:

$$N_{j,f,ref} = A.\Delta T_{j,ref}^{\alpha}.\exp(c/(k_B.T_{j,m,\,ref}))$$

wherein A, c and $\alpha$ are parameters determined empirically or by simulation for the respective semiconductor assembly and $k_B = 1.38.10^{-23}$ J/K.

8. Method according to one of claims 1 to 7, **characterized in that** the assessment algorithms comprise a rainflow count carried out on the basis of the low-cycle load-time curve, by means of which the frequency of a temperature rise ($\Delta T_C$) of a specific order of magnitude is counted for different orders of magnitude for the temperature ($T_C$) occurring in the support structure (2), and a computational determination of the maximum number of load cycles ($N_{c,f}$) for a temperature rise ($\Delta T_C$) of each order of magnitude, wherein the second damage characteristic value ($LC_{TC}$) is the sum of the quotients of the frequency of a temperature rise ($\Delta T_C$) of a specific order of magnitude for the temperature ($T_C$) occurring in the support structure (2) to the maximum number of load cycles ($N_{c,f}$) for a temperature rise ($\Delta T_C$) of the same order of magnitude.

9. Method according to claim 8, **characterized in that** an average value ($T_{C,m}$) for the temperature ($T_C$) occurring in the support structure (2) is determined from the temperature rise ($\Delta T_C$) of a specific order of magnitude for the temperature ($T_C$) occurring in the support structure (2) for the respective order of magnitude, and the computational determination of the maximum number of load cycles ($N_{C,f}$) for the temperature rise ($\Delta T_C$) of each order of magnitude is calculated according to the following formula:

$$N_{c,f} = B.\Delta T_C^{\beta}.\exp(d/(k_B.T_{C,m}))$$

wherein B, d and $\beta$ are parameters determined empirically or by simulation for the respective semiconductor assembly and $k_B = 1.38.10^{-23}$ J/K.

10. Method according to one of the claims 1 to 9, **characterized in that** a rainflow count is carried out on the basis of an expected low-cycle reference load-time curve, by means of which the frequency of a temperature rise ($\Delta T_{C,ref}$) of a specific order of magnitude is counted for different orders of magnitude for the temperature ($T_{C,ref}$) occurring in the support structure (2), and a computational determination of the maximum number of load cycles ($N_{C,f,ref}$) for a temperature rise ($\Delta T_{C,ref}$) of each order of magnitude, wherein the second reference value ($LC_{TC,ref}$) is the sum of the quotients of the frequency of a temperature rise ($\Delta T_{C,ref}$) of a specific order of magnitude for the temperature ($T_{C,ref}$) occurring in the support structure (2) to the maximum number of load cycles ($N_{C,f,ref}$) for a temperature rise ($\Delta T_{C,ref}$) of the same order of magnitude.

11. Method according to claim 10, **characterized in that** an average value ($T_{C,m,ref}$) for the temperature ($T_{C,ref}$) occurring in the support structure (2) is determined from the temperature rise ($\Delta T_{C,ref}$) of a specific order of magnitude for the temperature ($T_{C,ref}$) occurring in the support structure (2) for the respective order of magnitude, and the computational determination of the maximum number of load cycles ($N_{C,f,ref}$) for the temperature rise ($\Delta T_{C,ref}$) of each order of magnitude is calculated according to the following formula:

$$N_{c,f,ref} = B.\Delta T_{C,ref}{}^{\beta}.\exp(d/(k_B.T_{C,m,ref}))$$

wherein B, d and $\beta$ are parameters determined empirically or by simulation for the respective semiconductor assembly and $k_{B=}1.38.10^{-23}$ J/K.

12. A drive system converter comprising a processor arranged for carrying out the method according to one of claims 1 to 11.

**Revendications**

1. Procédé pour évaluer l'état de dégradation d'un module de semiconducteurs soumis à des contraintes en fonctionnement, en particulier d'un convertisseur de traction, avec au moins un élément semiconducteur (1) disposé sur une structure de support (2), dans lequel une température ($T_j$) régnant à l'intérieur de l'élément semiconducteur (1) est déterminée sous la forme d'une série temporelle comme une courbe de charge-temps mégacyclique, à laquelle une première valeur caractéristique de dégradation ($LC_{PC}$) est associée à l'aide d'algorithmes d'analyse connus, et une température ($T_c$) régnant dans la structure de support (2) est déterminée sous la forme d'une série temporelle comme une courbe de charge-temps oligocyclique à laquelle une deuxième valeur caractéristique de dégradation ($LC_{TC}$) est associée à l'aide des algorithmes d'analyse connus, la courbe charge-temps mégacyclique et la courbe charge-temps oligocyclique représentant chacune des contraintes thermiques variables dans le temps, dont les cycles d'oscillation se déroulent à des vitesses différentes, les cycles d'oscillation des contraintes mégacycliques étant plus rapides que ceux des contraintes oligocycliques, **caractérisé en ce que** la première valeur caractéristique de dégradation ($LC_{PC}$) est associée, afin d'identifier une plage mégacyclique d'états de fonctionnement réels du module de semiconducteurs par la comparaison de la première valeur caractéristique de dégradation ($LC_{PC}$) avec une première valeur de référence ($LC_{PC,ref}$) prédéterminée, à une plage non critique d'états de fonctionnement, une plage critique et une plage surcritique de contraintes mégacycliques du module de semiconducteurs et la deuxième valeur caractéristique de dégradation ($LC_{TC}$) est associée, afin d'identifier une plage oligocyclique d'états de fonctionnement réels du module de semiconducteurs par la comparaison de la deuxième valeur caractéristique de dégradation ($LC_{TC}$) avec une deuxième valeur de référence ($LC_{TC,ref}$), à une plage non critique d'états de fonctionnement, une plage critique et une plage surcritique de contraintes oligocycliques du module de semiconducteurs, et un premier signal d'indication est ensuite généré si les plage mégacyclique et oligocyclique d'états de fonctionnement réels correspondent à une plage non critique d'états de fonctionnement, un deuxième signal d'indication est généré si la plage mégacyclique ou oligocyclique d'états de fonctionnement correspond à une plage critique d'états de fonctionnement et aucune des deux plages ne correspond à une plage critique d'états de fonctionnement, et un troisième signal d'indication est généré si les plages mégacyclique et oligocyclique d'états de fonctionnement réels correspondent à une plage surcritique d'états de fonctionnement, où

- ) l'évolution dans le temps de la première valeur de référence ($LC_{PC,ref}$) et de la deuxième valeur de référence ($LC_{TC,ref}$) pendant le fonctionnement du module de semiconducteurs étant une fonction prédéterminée croissante de façon monotone, qui prend la valeur 1 quand la durée de vie maximale est atteinte, et
- ) la détermination de la première valeur caractéristique de dégradation ($LC_{PC}$) étant fréquemment répétée pendant le fonctionnement du convertisseur à des intervalles de temps prédéterminés, à l'aide de courbes de charge-temps mégacycliques actualisées, et comparée à la première valeur de référence ($LC_{PC,ref}$), et
- ) la détermination de la deuxième valeur caractéristique de dégradation ($LC_{TC}$) étant fréquemment répétée pendant le fonctionnement du convertisseur à des intervalles de temps prédéterminés, à l'aide de courbes de charge-temps oligocycliques actualisées, et comparée à la deuxième valeur de référence ($LC_{TC,ref}$), pour générer dans chaque cas un signal d'indication de l'état de charge actuel.

2. Procédé selon la revendication 1, **caractérisé en ce que** la plage d'états de fonctionnement est non critique si la valeur caractéristique de dégradation ($LC_{PC}$, $LC_{TC}$) se situe en dessous d'une plage d'écart de la valeur de référence ($LC_{PC,ref}$, $LC_{TC,ref}$) associée, la plage de fonctionnement est critique si la valeur caractéristique de dégradation ($LC_{PC}$, $LC_{TC}$) se situe dans la plage d'écart de la valeur de référence $LC_{PC,ref}$, $LC_{TC,ref}$) associée et la plage de fonctionnement est surcritique si la valeur caractéristique de dégradation ($LC_{PC}$, $LC_{TC}$) se situe au-dessus de la plage d'écart de la valeur de référence ($LC_{PC,ref}$, $LC_{TC,ref}$) associée.

3. Procédé selon la revendication 2, **caractérisé en ce que** la plage d'écart des valeurs de référence ($LC_{PC,ref}$, $LC_{TC,ref}$) se situe dans une plage de valeurs de 80 à 100 % des valeurs de référence ($LC_{PC,ref}$, $LC_{TC,ref}$).

4. Procédé selon l'une des revendications 1 à 3, **caractérisé en ce que** les algorithmes d'analyse comprennent un comptage rainflow exécuté à l'aide de la courbe charge-temps mégacyclique, au moyen duquel la fréquence d'un écart de température ($\Delta T_j$) d'un certain ordre de grandeur est comptée pour la température ($T_j$) régnant à l'intérieur de l'élément semiconducteur pour différents ordres de grandeur, ainsi que le calcul du nombre maximal de cycles de charge ($N_{j,f}$) pour un écart de température ($\Delta T_j$) de chaque ordre de grandeur, la première valeur caractéristique de dégradation ($LC_{PC}$) étant la somme des quotients de la fréquence d'un écart de température ($\Delta T_j$) d'un ordre de grandeur donné pour la température ($T_j$) régnant à l'intérieur de l'élément semiconducteur et du nombre maximal de cycles de charge ($N_{j,f}$) pour un écart de température ($\Delta T_j$) du même ordre de grandeur.

5. Procédé selon la revendication 4, **caractérisé en ce qu'**une moyenne ($T_{j,m}$) est calculée à partir de l'écart de température ($\Delta T_j$) d'un certain ordre de grandeur pour la température ($T_j$) régnant à l'intérieur de l'élément semiconducteur pour l'ordre de grandeur en question et le nombre maximal de cycles de charge ($N_{j,f}$) pour l'écart de température ($\Delta T_j$) de chaque ordre de grandeur est calculé selon la formule suivante :

$$N_{j,f} = A \cdot \Delta T_j^{\alpha} \cdot \exp\left(c / (k_B \cdot T_{j,m})\right)$$

où A, c et $\alpha$ sont des paramètres déterminés empiriquement ou au moyen d'une simulation pour le module de semiconducteurs en question et $k_B$ = 1,38 · 10$^{-23}$ J/K.

6. Procédé selon l'une des revendications 1 à 5, **caractérisé en ce qu'**un comptage rainflow est exécuté à l'aide d'une courbe charge-temps mégacyclique de référence, au moyen de laquelle la fréquence d'un écart de température ($\Delta T_{j,ref}$) d'un certain ordre de grandeur est comptée pour la température ($T_{j,ref}$) régnant à l'intérieur de l'élément semiconducteur pour différents ordres de grandeur, ainsi qu'un calcul du nombre maximal de cycles de charge ($N_{j,f,ref}$) pour un écart de température ($\Delta T_{j,ref}$) de chaque ordre de grandeur, la première valeur de référence ($LC_{PC,ref}$) étant la somme des quotients de la fréquence d'un écart de température ($\Delta T_{j,ref}$) d'un certain ordre de grandeur pour la température ($T_{j,ref}$) régnant à l'intérieur de l'élément semiconducteur et du nombre maximal de cycles de charge ($N_{j,f,ref}$) pour un écart de température ($\Delta T_{j,ref}$) du même ordre de grandeur.

7. Procédé selon la revendication 6, **caractérisé en ce qu'**une moyenne ($T_{j,m,ref}$) est calculée à partir de l'écart de température ($\Delta T_{j,ref}$) d'un certain ordre de grandeur pour la température ($T_{j,ref}$) régnant à l'intérieur de l'élément semiconducteur pour l'ordre de grandeur en question et le nombre maximal de cycles de charge ($N_{j,f,ref}$) pour l'écart de température ($\Delta T_{j,ref}$) de chaque ordre de grandeur est calculé selon la formule suivante :

$$N_{j,f,ref} = A \cdot \Delta T_{j,ref}^{\alpha} \cdot \exp\left(c / (k_B \cdot T_{j,m,ref})\right)$$

où A, c et $\alpha$ sont des paramètres déterminés empiriquement ou au moyen d'une simulation pour le module de semiconducteurs en question et $k_B$ = 1,38 · 10$^{-23}$ J/K.

8. Procédé selon l'une des revendications 1 à 7, **caractérisé en ce que** les algorithmes d'analyse comprennent un comptage rainflow exécuté à l'aide de la courbe charge-temps oligocyclique, au moyen duquel la fréquence d'un écart de température ($\Delta T_c$) d'un certain ordre de grandeur est comptée pour la température ($T_c$) régnant dans la structure de support (2) pour différents ordres de grandeur, ainsi que le calcul du nombre maximal de cycles de charge ($N_{c,f}$) pour un écart de température ($\Delta T_c$) de chaque ordre de grandeur, la deuxième valeur caractéristique de dégradation ($LC_{TC}$) étant la somme des quotients de la fréquence d'un écart de température ($\Delta T_c$) d'un ordre de grandeur donné pour la température ($T_c$) régnant à l'intérieur de la structure de support (2) et du nombre maximal de cycles de charge ($N_{c,f}$) pour un écart de température ($\Delta T_c$) du même ordre de grandeur.

9. Procédé selon la revendication 8, **caractérisé en ce qu'**une moyenne ($T_{C,m}$) est calculée à partir de l'écart de température ($\Delta T_c$) d'un certain ordre de grandeur pour la température ($T_c$) régnant à l'intérieur de la structure de support (2) pour l'ordre de grandeur en question et le nombre maximal de cycles de charge ($N_{c,f}$) pour l'écart de température ($\Delta T_c$) de chaque ordre de grandeur est calculé selon la formule suivante :

$$N_{c,f} = B \cdot \Delta T_c{}^{\beta} \cdot \exp \left( d / \left( k_B \cdot T_{c,m} \right) \right)$$

où B, d et $\beta$ sont des paramètres déterminés empiriquement ou au moyen d'une simulation pour le module de semiconducteurs en question et $k_B$ = 1,38 . $10^{-23}$ J/K.

10. Procédé selon l'une des revendications 1 à 9, **caractérisé en ce qu'**un comptage rainflow est exécuté à l'aide d'une courbe charge-temps oligocyclique attendue, au moyen de laquelle la fréquence d'un écart de température ($\Delta T_{c,ref}$) d'un certain ordre de grandeur est comptée pour la température ($T_{c,ref}$) régnant à l'intérieur de la structure de support (2) pour différents ordres de grandeur, ainsi qu'un calcul du nombre maximal de cycles de charge ($N_{c,f,ref}$) pour un écart de température ($\Delta T_{c,ref}$) de chaque ordre de grandeur, la deuxième valeur de référence ($LC_{TC,ref}$) étant la somme des quotients de la fréquence d'un écart de température ($\Delta T_{c,ref}$) d'un certain ordre de grandeur pour la température ($T_{c,ref}$) régnant à l'intérieur de la structure de support (2) et du nombre maximal de cycles de charge ($N_{c,f,ref}$) pour un écart de température($\Delta T_{c,ref}$) du même ordre de grandeur.

11. Procédé selon la revendication 10, **caractérisé en ce qu'**une moyenne ($T_{c,m,ref}$) est calculée à partir de l'écart de température ($\Delta T_{c,ref}$) d'un certain ordre de grandeur pour la température ($T_{c,ref}$) régnant à l'intérieur de la structure de support (2) pour l'ordre de grandeur en question et le nombre maximal de cycles de charge ($N_{c,f,ref}$) pour l'écart de température ($\Delta T_{c,ref}$) de chaque ordre de grandeur est calculé selon la formule suivante :

$$N_{c,f,ref} = B \cdot \Delta T_{c,ref}{}^{\beta} \cdot \exp \left( d / \left( k_B \cdot T_{c,m,ref} \right) \right)$$

où B, d et $\beta$ sont des paramètres déterminés empiriquement ou au moyen d'une simulation pour le module de semiconducteurs en question et $k_B$ = 1,38 · $10^{-23}$ J/K.

12. Convertisseur de traction muni d'un processeur paramétré pour exécuter le procédé selon l'une des revendications 1 à 11.

Fig. 1

Fig. 2

## Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102013221587 A1
- DE 102011087764 A1
- DE 102014206621 A1
- DE 10203577 A1
- DE 102009032063 A1
- US 9869722 B1